# EUROPEAN PATENT APPLICATION

(11) **EP 4 814 155 A1**
(43) Date of publication of application: **30.09.2026**
(21) Application number: 24894093.4
(22) Date of filing: 15.11.2024
(51) Int. Cl.: C23C 14/04

(54) **MASK AND MASK MANUFACTURING METHOD**

(30) Priority: 22.11.2023 JP 2023198636
(71) Applicant: Dai Nippon Printing Co., Ltd., Tokyo 162-8001 (JP)
(72) Inventor: FURUSYOU, Hiroki, Tokyo 162-8001 (JP); AMIE, Takashi, Tokyo 162-8001 (JP); KIURA, Shinya, Tokyo 162-8001 (JP); INOUE, Isao, Tokyo 162-8001 (JP)
(74) Representative: Müller-Boré & Partner Patentanwälte PartG mbB
(86) International application number: PCT/JP2024/040613
(87) International publication number: WO 2025/110102

(57) **Abstract**

A mask may include: a base material including a base material first surface, a base material second surface located on a side opposite to the base material first surface, and at least one first opening penetrating from the base material first surface to the base material second surface; and a mask layer including a first surface facing the base material second surface and a second surface located on a side opposite to the first surface. The mask layer may include a plurality of first regions overlapping the first opening in plan view and a second region located between, and outside of, the plurality of first regions in plan view. The plurality of first regions may each include a plurality of second openings penetrating from the first surface to the second surface. The second surface of the first regions has a first arithmetic mean roughness (Ra1) relating to line roughness, and a first arithmetic mean roughness (Sa1) and a first maximum height (Sz1) relating to surface roughness. The first arithmetic mean roughness (Ra1) may be 50 nm or less. The first maximum height (Sz1) may be 1000 nm or less. Sa1/Ra1, which is a ratio of the first arithmetic mean roughness (Sa1) to the first arithmetic mean roughness (Ra1), may be 1.82 or less.

## Description

### Technical Field

Embodiments of the present disclosure relate to a mask and a method for manufacturing the mask.

### Background Art

A vapor deposition method is known as a method for forming a precise pattern. In the vapor deposition method, first, a mask in which openings are formed is combined with a display substrate. Subsequently, a vapor deposition material is caused to adhere to the display substrate through the openings of the mask. As a result, a vapor deposition layer containing the vapor deposition material is formed on the display substrate in a pattern corresponding to the pattern of the openings of the mask. The vapor deposition method is used, for example, as a method for forming pixels of an organic EL display device.

For example, Patent Literature 1 discloses a mask including a mask substrate in which a plurality of openings are formed and an outer frame substrate that supports the mask substrate. Patent Literature 1 proposes to employ a thin mask substrate. Since the mask substrate is thin, high definition vapor deposition is realized.

### Citation List

### Patent Literature

PTL 1: Japanese Unexamined Patent Application Publication No. 2013-163864

### Summary of Invention

### Technical Problem

When a surface of a mask facing a display substrate has minute undulations, a gap is formed between the display substrate and the mask according to the undulations. When a vapor deposition material enters the gap, the shape of a vapor deposition layer deviates from the ideal shape. For example, the outline of the vapor deposition layer partially deviates from the ideal line. For example, the thickness of the vapor deposition layer in the outline portion of the vapor deposition layer partially deviates from the ideal thickness.

### Solution to Problem

A mask according to an embodiment of the present disclosure may include: a base material including a base material first surface, a base material second surface located on a side opposite to the base material first surface, and at least one first opening penetrating from the base material first surface to the base material second surface; and a mask layer including a first surface facing the base material second surface and a second surface located on a side opposite to the first surface. The mask layer may include a plurality of first regions overlapping the first opening in plan view and a second region located between, and outside of, the plurality of first regions in plan view. The plurality of first regions may each include a plurality of second openings penetrating from the first surface to the second surface. The second surface of the first regions has a first arithmetic mean roughness (Ra1) relating to line roughness, and a first arithmetic mean roughness (Sa1) and a first maximum height (Sz1) relating to surface roughness. The first arithmetic mean roughness (Ra1) may be 50 nm or less. The first maximum height (Sz1) may be 1000 nm or less. Sa1/Ra1, which is a ratio of the first arithmetic mean roughness (Sa1) to the first arithmetic mean roughness (Ra1), may be 1.82 or less.

### Advantageous Effects of Invention

According to an embodiment of the present disclosure, deviation of the shape of the vapor deposition layer from an ideal shape can be suppressed.

### Brief Description of Drawings

[Fig. 1] Fig. 1 is a cross-sectional view showing an example of an organic device.
[Fig. 2] Fig. 2 is a view showing an example of a vapor deposition apparatus provided with a mask.
[Fig. 3A] Fig. 3A is a plan view showing an example of the incident surface of the mask.
[Fig. 3B] Fig. 3B is a plan view showing an example of the incident surface of the mask.
[Fig. 4] Fig. 4 is a plan view showing an example of the exit surface of the mask.
[Fig. 5] Fig. 5 is a cross-sectional view of the mask of Fig. 3A taken along line V-V.
[Fig. 6] Fig. 6 is a cross-sectional view showing an example of a first region.
[Fig. 7] Fig. 7 is a cross-sectional view showing an example of a twenty-first region.
[Fig. 8] Fig. 8 is a plan view showing an example of a vapor deposition layer having an ideal shape.
[Fig. 9] Fig. 9 is a cross-sectional view taken along line IX-IX of the vapor deposition layer of Fig. 8.
[Fig. 10] Fig. 10 is a plan view showing an example of a vapor deposition layer having a shape deviating from an ideal shape.
[Fig. 11] Fig. 11 is a cross-sectional view taken along line XI-XI of the vapor deposition layer of Fig. 10.
[Fig. 12] Fig. 12 is a plan view showing a measurement region of a mask layer.
[Fig. 13] Fig. 13 is a plan view showing specific measurement positions in the measurement of line roughness.
[Fig. 14] Fig. 14 is a plan view showing specific measurement positions in the measurement of surface roughness.
[Fig. 15] Fig. 15 is a cross-sectional view showing an example of a step of forming an intermediate layer.
[Fig. 16] Fig. 16 is a cross-sectional view showing an example of a step of forming an insulating layer.
[Fig. 17A] Fig. 17A is a cross-sectional view showing an example of a step of processing the insulating layer.
[Fig. 17B] Fig. 17B is a plan view showing an example of the step of processing the insulating layer.
[Fig. 18] Fig. 18 is a cross-sectional view showing an example of a step of forming a metal layer.
[Fig. 19] Fig. 19 is a cross-sectional view showing an example of a step of polishing a metal second surface of the metal layer.
[Fig. 20] Fig. 20 is a cross-sectional view showing an example of a step of removing the insulating layer.
[Fig. 21] Fig. 21 is a cross-sectional view showing an example of a step of forming a protective layer and a resist layer.
[Fig. 22] Fig. 22 is a cross-sectional view showing an example of a step of processing a base material.
[Fig. 23] Fig. 23 is a cross-sectional view showing an example of a step of removing the protective layer.
[Fig. 24] Fig. 24 is a cross-sectional view showing an example of a vapor deposition step.
[Fig. 25] Fig. 25 is a view showing a shadowing evaluation method.
[Fig. 26] Fig. 26 is a cross-sectional view showing an example of a separation step.
[Fig. 27] Fig. 27 is a cross-sectional view showing an example of a separation step in a comparative embodiment.
[Fig. 28] Fig. 28 is a cross-sectional view showing an example of a mask in the first modification.
[Fig. 29] Fig. 29 is a cross-sectional view showing an example of the twenty-first region in the first modification.
[Fig. 30A] Fig. 30A is a cross-sectional view showing an example of the step of processing the insulating layer in the first modification.
[Fig. 30B] Fig. 30B is a plan view showing an example of the step of processing the insulating layer in the first modification.
[Fig. 31] Fig. 31 is a cross-sectional view showing an example of the step of forming the metal layer in the first modification.
[Fig. 32] Fig. 32 is a cross-sectional view showing an example of the step of polishing the metal second surface of the metal layer in the first modification.
[Fig. 33] Fig. 33 is a cross-sectional view showing an example of the step of forming a protective layer in the first modification.
[Fig. 34] Fig. 34 is a cross-sectional view showing an example of a mask in the second modification.
[Fig. 35] Fig. 35 is a cross-sectional view showing an example of a mask in the third modification.
[Fig. 36] Fig. 36 is a view showing an example of an apparatus including the organic device.
[Fig. 37] Fig. 37 is a table showing the measurement results of the surface roughness in the first regions in Example 1.
[Fig. 38] Fig. 38 is a table showing the measurement results of the surface roughness in the second region in Example 1.
[Fig. 39] Fig. 39 is a table showing the evaluation results in Examples 1 to 11.
[Fig. 40] Fig. 40 is a view showing an example of an image of a vapor deposition layer.
[Fig. 41] Fig. 41 is a view showing an example of an image of a vapor deposition layer.

### Description of Embodiments

In the present specification and the drawings, unless otherwise specified, terms such as "substrate", "sheet", and "film", which mean a substance serving as a base of a certain configuration, are not distinguished from one another based only on the difference in designation.

In the present specification and the drawings, unless otherwise specified, terms such as "parallel" and "orthogonal", values of length and angle, and the like, which specify shapes, geometric conditions, and degrees thereof, are not bound by their strict meanings, and are interpreted to include the ranges in which similar functions are expected.

In the present specification and the drawings, unless otherwise specified, when an element such as a member or a region is referred to as being "on" or "beneath", "over" or "under", or "above" or "below" another element such as another member or another region, cases where the element is in direct contact with the other element are included. Furthermore, a case where another component is included between a certain element and another element, that is, a case where the two elements are in indirect contact with each other, is also included. In addition, unless otherwise specified, the terms "on", "over", "above", "beneath", "under", and "below" may be reversed in the vertical direction.

In the present specification, when a plurality of upper limit value candidates and a plurality of lower limit value candidates are listed for a certain parameter, the numerical range of the parameter may be configured by combining any one of the upper limit value candidates and any one of the lower limit value candidates. For example, consider a case where it is described that "The parameter B is, for example, A1 or more, may be A2 or more, or may be A3 or more. The parameter B is, for example, A4 or less, may be A5 or less, or may be A6 or less.". In this case, the numerical value range of the parameter B may be A1 or more and A4 or less, A1 or more and A5 or less, A1 or more and A6 or less, A2 or more and A4 or less, A2 or more and A5 or less, A2 or more and A6 or less, A3 or more and A4 or less, A3 or more and A5 or less, or A3 or more and A6 or less.

In the present specification and the drawings, unless otherwise specified, a state in which a surface of an element A faces a surface of an element B includes not only a case where the surface of the element A is in contact with the surface of the element B, but also a case where an element C is located between the surface of the element A and the surface of the element B. That is, the term "facing" is a term representing the orientation of the two surfaces.

In the present specification and the drawings, the same portions or portions having similar functions are denoted by the same reference signs or similar reference signs unless otherwise specified, and the repeated description thereof may be omitted. In addition, the dimensional ratios in the drawings may be different from the actual ratios for convenience of description, or a part of the configurations may be omitted from the drawings.

In the present specification and the drawings, unless otherwise specified, one embodiment of the present specification can be combined with another example to the extent that no contradiction occurs. In addition, other examples can be combined with each other to the extent that no contradiction occurs.

In the present specification and the drawings, when two or more steps or processes relating to a method such as the manufacturing method are disclosed, unless otherwise specified, other steps or processes that are not disclosed may be performed between the disclosed steps or processes. In addition, the disclosed steps or processes may be performed in any order to the extent that no contradiction occurs.

In an embodiment of the present specification, an example in which a mask is used to form an organic layer or an electrode on a substrate when manufacturing an organic EL display device will be described. However, the application of the mask is not particularly limited, and the present embodiment can be applied to masks used for various applications. For example, the mask of the present embodiment may be used to form an electrode of a device for displaying or projecting an image or a video for expressing virtual reality, so-called VR, or augmented reality, so-called AR. Further, the mask of the present embodiment may be used to form an electrode of a display device other than organic EL display devices, such as an electrode of a liquid crystal display device. Further, the mask of the present embodiment may be used to form a constituent element of a device other than display devices, such as an electrode of a pressure sensor.

A first aspect of the present disclosure is a mask comprising:
a base material including a base material first surface, a base material second surface located on a side opposite to the base material first surface, and at least one first opening penetrating from the base material first surface to the base material second surface; and
a mask layer including a first surface facing the base material second surface and a second surface located on a side opposite to the first surface,
wherein the mask layer includes a plurality of first regions overlapping the first opening in plan view and a second region located between, and outside of, the plurality of first regions in plan view,
the plurality of first regions each include a plurality of second openings penetrating from the first surface to the second surface,
the second surface of the first regions has a first arithmetic mean roughness (Ra1) relating to line roughness, and a first arithmetic mean roughness (Sa1) and a first maximum height (Sz1) relating to surface roughness,
the first arithmetic mean roughness (Ra1) is 50 nm or less,
the first maximum height (Sz1) is 1000 nm or less, and
Sa1/Ra1, which is a ratio of the first arithmetic mean roughness (Sa1) to the first arithmetic mean roughness (Ra1), is 1.82 or less.

A second aspect of the present disclosure may include the following features in the mask according to the first aspect described above. The second surface of the second region may have a second arithmetic mean roughness (Ra2) relating to line roughness, and the first arithmetic mean roughness (Ra1) may be different from the second arithmetic mean roughness (Ra2).

A third aspect of the present disclosure may include the following features in the mask according to the second aspect described above. The first arithmetic mean roughness (Ra1) may be greater than the second arithmetic mean roughness (Ra2).

A fourth aspect of the present disclosure may include the following features in the mask according to any one of the first to third aspects described above. The second surface of the second region may have a second arithmetic mean roughness (Sa2) relating to surface roughness, and the first arithmetic mean roughness (Sa1) may be different from the second arithmetic mean roughness (Sa2).

A fifth aspect of the present disclosure may include the following features in the mask according to the fourth aspect described above. The first arithmetic mean roughness (Sa1) may be greater than the second arithmetic mean roughness (Sa2).

A sixth aspect of the present disclosure may include the following features in the mask according to any one of the first to fifth aspects described above. The second surface of the second region may have a second maximum height (Sz2) relating to surface roughness, and the first maximum height (Sz1) may be different from the second maximum height (Sz2).

A seventh aspect of the present disclosure may include the following features in the mask according to the sixth aspect described above. The first maximum height (Sz1) may be smaller than the second maximum height (Sz2).

An eighth aspect of the present disclosure may include the following features in the mask according to any one of the first to seventh aspects described above. In-plane directions of the second surface may include an x direction and a y direction orthogonal to the x direction, and the first arithmetic mean roughness (Ra1) may be an average of an arithmetic mean roughness of the second surface of the first regions in the x direction and an arithmetic mean roughness of the second surface of the first regions in the y direction, and a ratio of a difference between the arithmetic mean roughness of the second surface of the first regions in the x direction and the arithmetic mean roughness of the second surface of the first regions in the y direction to the first arithmetic mean roughness (Ra1) may be 0.50 or less.

A ninth aspect of the present disclosure may include the following features in the mask according to any one of the first to eighth aspects described above. The first regions may include metal layer.

A tenth aspect of the present disclosure may include the following features in the mask according to the ninth aspect described above. The second region may include a metal layer.

An eleventh aspect of the present disclosure may include the following features in the mask according to the ninth aspect described above. The second region may include an insulating layer.

A twelfth aspect of the present disclosure may include the following features in the mask according to the eleventh aspect described above. The insulating layer may contain silicon oxide.

A thirteenth aspect of the present disclosure may include the following features in the mask according to any one of the first to twelfth aspects described above. The mask may include an intermediate layer that is located between the mask layer and the base material and that contains a metal.

A fourteenth aspect of the present disclosure may include the following features in the mask according to any one of the first to thirteenth aspects described above. The base material may contain silicon or a silicon compound.

A fifteenth aspect of the present disclosure is a method for manufacturing a mask, the method comprising:
a base material preparation step of preparing a base material including a base material first surface and a base material second surface located on a side opposite to the base material first surface;
an insulating layer forming step of forming an insulating layer including an insulating first surface facing the base material second surface and an insulating second surface located on a side opposite to the insulating first surface, and including at least a plurality of island portions;
a metal layer forming step of forming a metal layer between the plurality of island portions, the metal layer including a metal first surface facing the base material second surface and a metal second surface located on a side opposite to the metal first surface;
a polishing step of polishing the metal second surface;
an insulating layer removing step of removing the plurality of island portions; and a base material processing step of forming a first opening in the base material, the first opening overlapping the metal layer in plan view,
wherein the mask includes a mask layer including a plurality of first regions including the metal layer overlapping the first opening in plan view and a second region including the metal layer or the insulating layer located between, and outside of, the plurality of first regions in plan view,
the mask layer includes a first surface facing the base material second surface and a second surface located on a side opposite to the first surface,
the second surface of the first regions has a first arithmetic mean roughness (Ra1) relating to line roughness, and a first arithmetic mean roughness (Sa1) and a first maximum height (Sz1) relating to surface roughness,
the first arithmetic mean roughness (Ra1) is 50 nm or less,
the first maximum height (Sz1) is 1000 nm or less, and
Sa1/Ra1, which is a ratio of the first arithmetic mean roughness (Sa1) to the first arithmetic mean roughness (Ra1), is 1.82 or less.

A sixteenth aspect of the present disclosure may include the following features in the method for manufacturing a mask according to the fifteenth aspect described above. The polishing step may include a step of bringing a slurry containing a working fluid and abrasive grains into contact with the insulating second surface and the metal second surface.

A seventeenth aspect of the present disclosure may include the following features in the method for manufacturing a mask according to the fifteenth aspect or the sixteenth aspect described above. The second surface of the second region may have a second arithmetic mean roughness (Ra2) relating to line roughness, and the first arithmetic mean roughness (Ra1) may be different from the second arithmetic mean roughness (Ra2).

An eighteenth aspect of the present disclosure may include the following features in the method for manufacturing a mask according to the seventeenth aspect described above. The first arithmetic mean roughness (Ra1) may be greater than the second arithmetic mean roughness (Ra2).

A nineteenth aspect of the present disclosure may include the following features in the method for manufacturing a mask according to any one of the fifteenth to eighteenth aspects described above. In the metal layer forming step, the metal layer may also be formed outside the plurality of island portions, and the second region may include the metal layer located outside the plurality of first regions.

A twentieth aspect of the present disclosure may include the following features in the method for manufacturing a mask according to any one of the fifteenth to nineteenth aspects described above. The insulating layer forming step may form the insulating layer including a frame portion that defines outlines of a plurality of insulating openings, and the plurality of island portions located in each of the plurality of insulating openings, and the metal layer forming step may form the metal layer in the plurality of insulating openings.

An embodiment of the present disclosure will be described in detail with reference to the drawings. The embodiment described below is merely an example of embodiments of the present disclosure, and the present disclosure should not be interpreted as being limited to these embodiments.

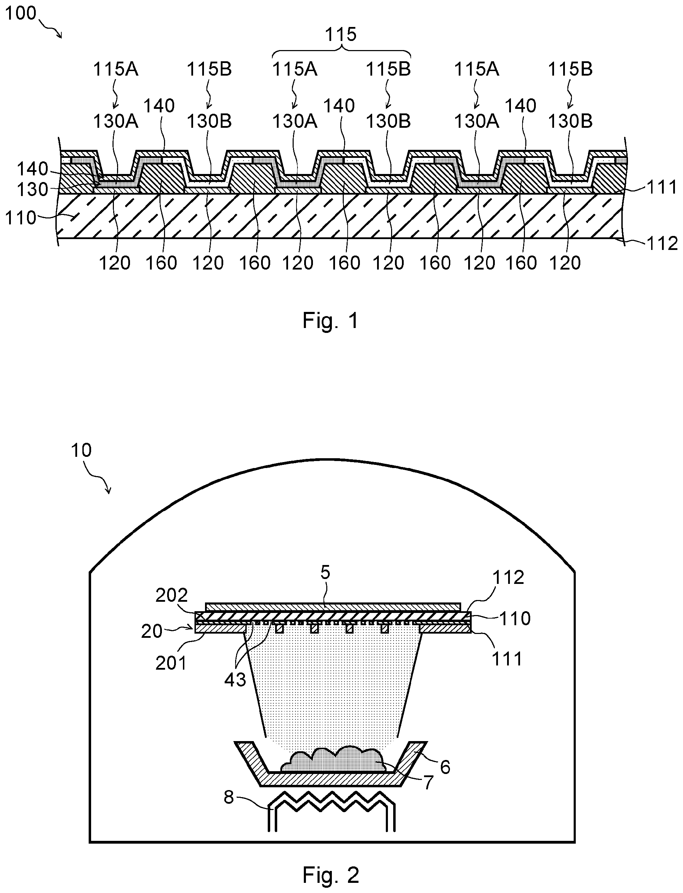

An organic device 100 including an organic layer formed by using a mask will be described. The organic device 100 includes an organic layer or an electrode formed by using a mask. Fig. 1 is a cross-sectional view showing an example of the organic device 100.

The organic device 100 includes a substrate 110 and a plurality of elements 115 arranged along the in-plane direction of the substrate 110. The substrate 110 includes a first surface 111 and a second surface 112 located on the side opposite to the first surface 111. The elements 115 are located on the first surface 111. The elements 115 are, for example, pixels. The substrate 110 may include two or more types of the elements 115. For example, the substrate 110 may include a first element 115A and a second element 115B. Although not shown, the substrate 110 may include a third element. The first element 115A, the second element 115B, and the third element are, for example, a red pixel, a blue pixel, and a green pixel.

The elements 115 may include a first electrode 120, an organic layer 130 located on the first electrode 120, and a second electrode 140 located on the organic layer 130.

The organic device 100 may include an insulating layer 160 located between two first electrodes 120 adjacent in plan view. The insulating layer 160 includes, for example, polyimide. The insulating layer 160 may overlap the end portion of the first electrode 120. The "plan view" means viewing an object along a normal direction of a surface of a plate-like member such as the substrate 110.

The substrate 110 may be a member having insulating properties. Examples of the material of the substrate 110 can include a non-flexible rigid material such as silicon, quartz glass, Pyrex (registered trademark) glass, or a synthetic quartz plate, and a flexible material having flexibility such as a resin film, an optical resin plate, or thin glass. The substrate 110 may have a planar shape similar to that of a silicon wafer used in semiconductor manufacturing. For example, the substrate 110 may have a circular shape in plan view. In this case, the substrate 110 can be processed using an apparatus that performs the semiconductor manufacturing process. For example, the first electrode 120, the insulating layer 160, and the like can be formed on the substrate 110 using the apparatus that performs the semiconductor manufacturing process.

The elements 115 are configured to realize a certain function when a voltage is applied between the first electrode 120 and the second electrode 140 or when a current flows between the first electrode 120 and the second electrode 140. For example, when the elements 115 are pixels of an organic EL display device, the elements 115 can emit light that constitutes an image.

The first electrode 120 includes electrically conductive material. For example, the first electrode 120 includes a metal, a conductive metal oxide, or another conductive inorganic material. The first electrode 120 may include a transparent and conductive metal oxide such as indium tin oxide.

The organic layer 130 includes organic material. When the organic layer 130 is energized, the organic layer 130 can perform some function. The energization means that a voltage is applied to the organic layer 130 or a current flows through the organic layer 130. Examples of the organic layer 130 can include a light-emitting layer that emits light when energized, and a layer whose light transmittance or refractive index changes when energized. The organic layer 130 may contain organic semiconductor material.

As shown in Fig. 1, the organic layer 130 may include a first organic layer 130A and a second organic layer 130B. The first organic layer 130A is included in the first element 115A. The second organic layer 130B is included in the second element 115B. Although not shown, the organic layer 130 may include a third organic layer included in the third element. The first organic layer 130A, the second organic layer 130B, and the third organic layer are, for example, a red light-emitting layer, a blue light-emitting layer, and a green light-emitting layer.

When a voltage is applied between the first electrode 120 and the second electrode 140, the organic layer 130 located between them is driven. When the organic layer 130 is a light-emitting layer, light is emitted from the organic layer 130, and the light is extracted to the outside from the second electrode 140 or the first electrode 120.

The organic layer 130 may further include a hole injection layer, a hole transport layer, an electron transport layer, an electron injection layer, and the like.

The second electrode 140 may include electrically conductive material such as metal. Examples of the material of the second electrode 140 can include platinum, gold, silver, copper, iron, tin, chromium, aluminum, indium, lithium, sodium, potassium, calcium, magnesium, chromium, carbon, and an alloy thereof. As shown in Fig. 1, the second electrode 140 may extend across the two organic layers 130 adjacent in plan view.

Next, a method for forming the organic layer 130 on the substrate 110 by a vapor deposition method will be described. Fig. 2 is a view showing a vapor deposition apparatus 10. The vapor deposition apparatus 10 performs the vapor deposition process of depositing a vapor deposition material on an object.

As shown in Fig. 2, the vapor deposition apparatus 10 may include a vapor deposition source 6, a heater 8, and a mask 20 therein. The vapor deposition apparatus 10 may further include an evacuation unit for creating a vacuum atmosphere inside the vapor deposition apparatus 10. The vapor deposition source 6 is, for example, a crucible. The vapor deposition source 6 contains a vapor deposition material 7 such as an organic material or a metal material. The heater 8 heats the vapor deposition source 6 to evaporate the vapor deposition material 7 under the vacuum atmosphere.

The mask 20 includes an incident surface 201, an exit surface 202, and second openings 43. The incident surface 201 faces the vapor deposition source 6. The exit surface 202 is located on the side opposite to the incident surface 201. The exit surface 202 faces the first surface 111 of the substrate 110. A part of the vapor deposition material 7 that has entered the mask 20 from the incident surface 201 passes through the second openings 43 and exits from the exit surface 202. The vapor deposition material 7 exiting from the exit surface 202 adheres to the first surface 111 of the substrate 110. The exit surface 202 of the mask 20 may be in contact with the first surface 111 of the substrate 110.

As shown in Fig. 2, the vapor deposition apparatus 10 may include a magnet 5 disposed facing the second surface 112 of the substrate 110. When the mask 20 includes magnetic material, the magnet 5 can attract the mask 20 toward the substrate 110 by the magnetic force. As a result, it is possible to reduce or eliminate the gap between the mask 20 and the substrate 110. Therefore, occurrence of shadowing in the vapor deposition step can be suppressed. In the present application, the shadowing is a phenomenon in which the thickness of the organic layer 130 formed near the wall surfaces of the second openings 43 is smaller than the thickness of the organic layer 130 formed at the centers of the second openings 43. The shadowing occurs due to, for example, adhesion of the vapor deposition material 7 to the wall surfaces of the mask 20 or the vapor deposition material 7 entering a gap between the mask 20 and the substrate 110.

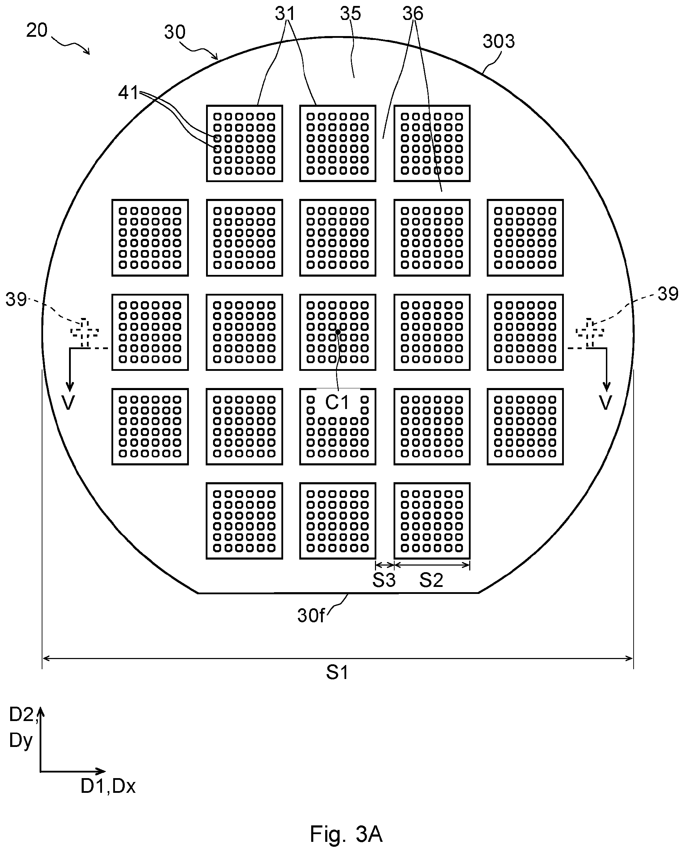

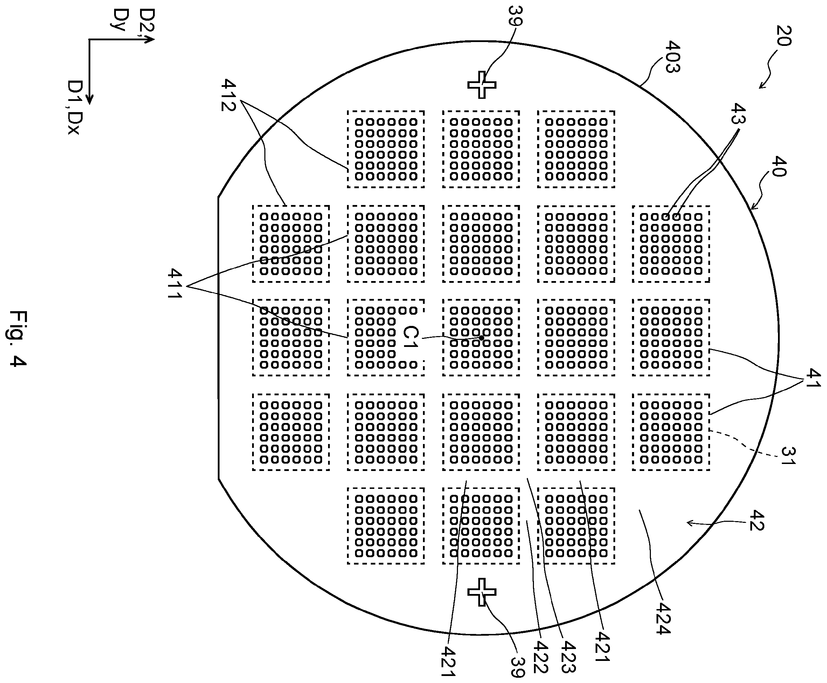

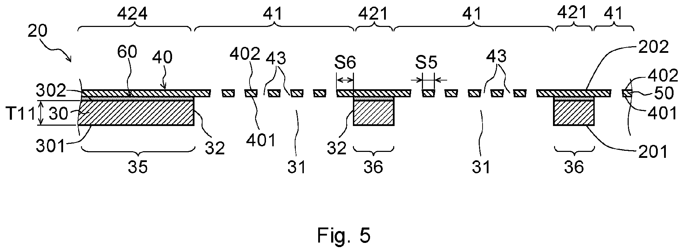

Next, the mask 20 will be described in detail. Fig. 3A is a plan view showing an example of the incident surface 201 of the mask 20. Fig. 4 is a plan view showing an example of the exit surface 202 of the mask 20. Fig. 5 is a cross-sectional view of the mask 20 of Fig. 3A taken along line V-V.

As shown in Fig. 5, the mask 20 includes a base material 30 and a mask layer 40. The mask 20 may include an intermediate layer 60.

The base material 30 includes a base material first surface 301, a base material second surface 302, a first opening 31, and a first wall surface 32. The base material first surface 301 may constitute the incident surface 201. The base material second surface 302 is located on the side opposite to the base material first surface 301. The first wall surface 32 is located between the base material first surface 301 and the base material second surface 302.

The first opening 31 penetrates from the base material first surface 301 to the base material second surface 302. As shown in Fig. 3A, the base material 30 may include a plurality of first openings 31. The plurality of first openings 31 may be arranged in a first direction D1 and a second direction D2. The second direction D2 may be orthogonal to the first direction D1. The first direction D1 and the second direction D2 are directions parallel to the base material first surface 301.

One first opening 31 may correspond to one screen of the organic EL display device. The mask 20 including a plurality of first openings 31 can simultaneously form the patterns of organic layers corresponding to a plurality of screens on the substrate 110. As shown in Fig. 3A, the first openings 31 may have a rectangular outline in plan view.

The first wall surface 32 faces and defines the first opening 31. In the example shown in Fig. 3A, the first wall surface 32 extends along the normal direction of the base material first surface 301.

As shown in Fig. 3A, the region of the base material 30 where the first openings 31 are not formed may be divided into an outer region 35 and an inner region 36. The inner region 36 is a region located between two first openings 31 adjacent in plan view. The outer region 35 is a region located between an outer edge 303 of the base material 30 and the first openings 31 in plan view. As shown in Fig. 3A, the inner region 36 may extend in the first direction D1 and the second direction D2.

As shown in Figs. 3A and 4, the base material 30 may include an alignment mark 39. The alignment mark 39 is formed, for example, on the base material second surface 302. The alignment mark 39 may be formed on the base material first surface 301. The alignment mark 39 is used, for example, to adjust the relative position of the substrate 110 with respect to the mask 20. When the substrate 110 has a property of transmitting visible light, the alignment mark 39 can be visually recognized through the substrate 110.

The alignment mark 39 may be formed in a layer other than the base material 30.

The base material 30 contains silicon or a silicon compound. The base material 30 is produced, for example, by processing a silicon wafer. As shown in Fig. 3A, the outer edge 303 of the base material 30 may include a linear portion. The linear portion is also referred to as an orientation flat 30f.

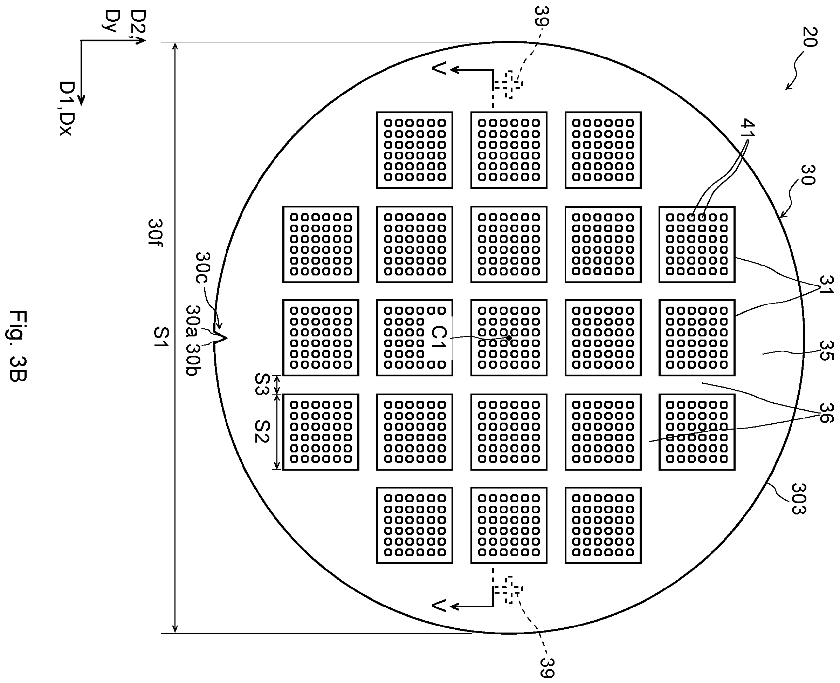

Fig. 3B is a plan view showing another example of the incident surface 201 of the mask 20. A cutout 30c may be formed in the outer edge 303 of the base material 30. The cutout 30c is also referred to as a notch. The cutout 30c may include two linear sides 30a and 30b. The sides 30a, 30b may extend from the outer edge 303 toward the center point of the mask 20 in plan view.

The orientation flat 30f and the notch 30c represent the crystal orientation of the silicon wafer constituting the base material 30.

The mask 20 may have an x direction Dx and a y direction Dy. The x direction Dx and the y direction Dy are in-plane directions of the incident surface 201 and the exit surface 202 of the mask 20. The x direction Dx and the y direction Dy are used as measurement directions of the surface roughness described later.

When the base material 30 includes the orientation flat 30f or the notch 30c, the x direction Dx is defined by the orientation flat 30f or the notch 30c. When the base material 30 includes the orientation flat 30f, the x direction Dx is the direction in which the linear portion of the orientation flat 30f extends. When the base material 30 includes the notch 30c, the x direction Dx is the direction orthogonal to the bisecting line that bisects the angle between the side 30a and the side 30b. The y direction Dy is the direction orthogonal to the x direction Dx. The x direction Dx may be parallel to the first direction D1. The y direction Dy may be parallel to the second direction D2.

When the base material 30 does not include the orientation flat 30f or the notch 30c, the x direction Dx and the y direction Dy are defined as directions parallel to the first direction D1 and the second direction D2.

The maximum size S1 of the base material 30 in plan view is, for example, 100 mm or more, and may be 150 mm or more, or 200 mm or more. The size S1 is, for example, 500 mm or less, and may be 400 mm or less, or 300 mm or less.

The size S2 of the first opening 31 in the direction in which the first openings 31 are arranged is, for example, 5 mm or more, and may be 10 mm or more, or 20 mm or more. The size S2 is, for example, 100 mm or less, may be 50 mm or less, or may be 30 mm or less.

The interval S3 between the two first openings 31 in the direction in which the first openings 31 are arranged is, for example, 0.1 mm or more, may be 0.5 mm or more, or may be 1.0 mm or more. The interval S3 is, for example, 20 mm or less, may be 15 mm or less, or may be 10 mm or less.

The thickness of the base material 30 is defined as the maximum thickness T11 of the outer region 35. The thickness T11 is, for example, 50 µm or more, may be 100 µm or more, or may be 200 µm or more. The thickness T11 is, for example, 1000 µm or less, may be 800 µm or less, or may be 600 µm or less.

Next, a mask layer 40 will be described. The mask layer 40 includes a first surface 401, a second surface 402, and a plurality of second openings 43. The first surface 401 faces the base material second surface 302. The second surface 402 is located on the side opposite to the first surface 401. The second surface 402 may constitute the exit surface 202 of the mask 20.

The second openings 43 penetrate from the first surface 401 to the second surface 402. One second opening 43 corresponds to one vapor deposition layer. The vapor deposition layer is, for example, the organic layer 130. A group of the plurality of second openings 43 arranged regularly corresponds to one screen of the organic EL display device. As shown in Fig. 3A and Fig. 4, a group of the plurality of second openings 43 arranged regularly may overlap one first opening 31 in plan view. A plurality of groups of the second openings 43 are supported by the base material 30.

The mask layer 40 may be divided into a first region 41 and a second region 42. The mask layer 40 includes a plurality of first regions 41. The plurality of first regions 41 each include a plurality of second openings 43. One first region 41 corresponds to one screen of the organic EL display device. One first region 41 may include a group of a plurality of second openings 43 arranged regularly. The plurality of first regions 41 each overlap the first opening 31 of the base material 30 in plan view.

The plurality of first regions 41 may be classified into an inner first region 411 and an outer first region 412. The inner first region 411 is the first region 41 that is located between the two first regions 41 in the first direction D1 and between the two first regions 41 in the second direction D2. The outer first region 412 is the first region 41 that is located outside the inner first region 411. The outer first region 412 is adjacent to only one first region 41 in either the first direction D1 or the second direction D2. The "outer" is a side away from the center point C1 of the mask 20 in plan view. The "inner" is a side closer to the center point C1 of the mask 20 in plan view.

The second region 42 is a region located between the plurality of first regions 41 and outside the plurality of first regions 41 in plan view. As shown in Figs. 4 and 5, the second region 42 may include twenty-first regions 421, twenty-second regions 422, twenty-third regions 423, and a twenty-fourth region 424. The twenty-first regions 421 are regions of the mask layer 40 located between two first regions 41 adjacent in the first direction D1. The twenty-second regions 422 are regions of the mask layer 40 located between two first regions 41 adjacent in the second direction D2. The twenty-third regions 423 are regions of the mask layer 40 surrounded by the twenty-first region 421 and the twenty-second region 422. The twenty-fourth region 424 is a region of the mask layer 40 located between the outer first region 412 and the outer edge 403 of the mask layer 40.

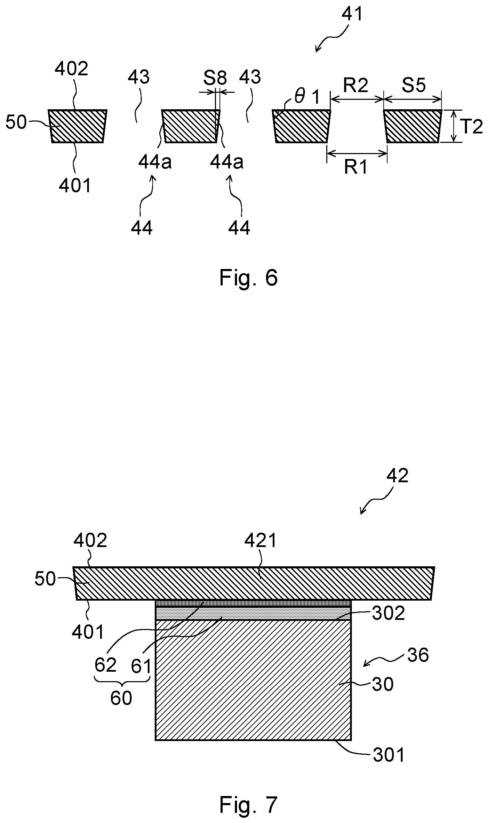

Fig. 6 is a cross-sectional view showing an example of the first region 41. The first region 41 includes a second wall surface 44 facing and defining the second opening 43. The first region 41 may include a metal layer 50. The first region 41 may be composed only of the metal layer 50.

The reference sign R1 represents the size of the second opening 43 on the first surface 401. The reference sign R2 represents the size of the second opening 43 on the second surface 402. The size R1 is also referred to as the first size. The size R2 is also referred to as the second size. The size of the vapor deposition layer formed on the substrate 110 by the vapor deposition step using the mask 20 is determined according to the second size R2.

The first size R1 may be greater than the second size R2. In other words, the second size R2 may be smaller than the first size R1. As a result, occurrence of shadowing in the vicinity of the second wall surface 44 can be suppressed. The first size R1 and the second size R2 are determined in the direction in which the second openings 43 are arranged.

As shown in Fig. 6, the second wall surface 44 may include a tapered surface 44a that widens so as to be separated from the center of the second opening 43 as going from the second surface 402 toward the first surface 401. Since the second wall surface 44 includes the tapered surface 44a, the size R1 can be made greater than the size R2.

In Fig. 6, the reference sign S8 represents the width of the tapered surface 44a in the direction in which the second openings 43 are arranged. The width S8 is, for example, 0.2 µm or more, may be 0.5 µm or more, or may be 1.0 µm or more. The width S8 is, for example, 25 µm or less, may be 20 µm or less, or may be 10 µm or less.

In Fig. 6, the reference sign θ1 represents the angle formed by the second wall surface 44 and the second surface 402. The angle θ1 is, for example, 50° or more, may be 55° or more, or may be 60° or more. The angle θ1 is, for example, less than 90°, may be 85° or less, or may be 80° or less.

The thickness T2 of the mask layer 40 in the first region 41 is smaller than the thickness T11 of the base material 30. The thickness T2 is, for example, 25.0 µm or less, may be 10.0 µm or less, or may be 5.0 µm or less. As a result, the occurrence of shadowing can be suppressed. The thickness T2 is, for example, 0.5 µm or more, may be 1.0 µm or more, or may be 2.0 µm or more. As a result, it is possible to suppress the occurrence of defects such as pinholes or deformation in the first region 41.

The interval S5 between the two second wall surfaces 44 in the direction in which the second openings 43 are arranged is, for example, 1.0 µm or more, may be 2.0 µm or more, or may be 3.0 µm or more. The interval S5 is, for example, 25.0 µm or less, may be 10.0 µm or less, or may be 5.0 µm or less.

The metal layer 50 contains metal. The metal may be magnetic material or non-magnetic material. The magnetic material is, for example, nickel, iron, cobalt, or an alloy thereof. The non-magnetic material is, for example, copper, aluminum, titanium, chromium, or an alloy thereof.

The first region 41 may include a layer other than the metal layer 50. The first region 41 may be composed of a layer other than the metal layer 50. For example, the first region 41 may include polycrystalline silicon or the like.

Fig. 7 is a cross-sectional view showing an example of a portion of the mask 20 corresponding to the twenty-first region 421 of the mask layer 40. The mask 20 includes the base material 30 constituting the inner region 36 and the mask layer 40 constituting the twenty-first region 421. The mask 20 may include an intermediate layer 60 located between the base material 30 and the mask layer 40.

The twenty-first region 421 may include a metal layer 50. The second region 42, such as the twenty-second region 422, the twenty-third region 423, and the twenty-fourth region 424, may also include the metal layer 50.

The intermediate layer 60 will be described. The intermediate layer 60 includes a layer that performs some function for the base material 30 or the mask layer 40. For example, the intermediate layer 60 includes a stopper layer 61. The stopper layer 61 is located between the base material second surface 302 of the base material 30 and the first surface 401 of the mask layer 40. The stopper layer 61 may be in contact with the base material second surface 302 of the base material 30.

The stopper layer 61 may have a function of stopping etching in a step of processing the base material 30 by etching. Specifically, the stopper layer 61 has resistance to the etchant for etching the base material 30. The stopper layer 61 may include metal such as aluminum, an aluminum alloy, titanium, or a titanium alloy. The aluminum alloy includes, for example, aluminum and neodymium. The stopper layer 61 may contain an inorganic compound such as silicon oxide.

The thickness of the stopper layer 61 is not particularly limited as long as etching of the mask layer 40 can be suppressed in the step of processing the base material 30. For example, the thickness of the stopper layer 61 may be smaller than the thickness of the mask layer 40, or may be greater than or equal to the thickness of the mask layer 40. The thickness of the stopper layer 61 is, for example, 5 nm or more, may be 50 nm or more, or may be 75 nm or more. The thickness of the stopper layer 61 is, for example, 100 µm or less, may be 50 µm or less, may be 10.0 µm or less, may be 5.0 µm or less, may be 1.0 µm or less, or may be 150 nm or less. The higher the resistance of the stopper layer 61 to the etchant for the base material 30, the smaller the thickness of the stopper layer 61 can be. It is particularly preferable that the thickness of the stopper layer 61 is 1.0 µm or less.

The intermediate layer 60 may include a seed layer 62. The seed layer 62 may be in contact with the first surface 401 of the mask layer 40. The seed layer 62 may be located between the stopper layer 61 and the first surface 401.

The seed layer 62 carries electric charges to the plating solution when the metal layer 50 of the mask layer 40 is formed by electrolytic plating. The seed layer 62 may include metal. Examples of the metal include nickel, copper, titanium, aluminum, and alloys thereof. The seed layer 62 may be constituted by one layer or may be constituted by a plurality of layers. For example, the seed layer 62 may include a first layer containing titanium, located on the stopper layer 61, and a second layer containing copper, located on the first layer.

The thickness of the seed layer 62 is, for example, 2.0 nm or more, may be 10.0 nm or more, or may be 30.0 nm or more. The thickness of the seed layer 62 is, for example, 5.0 µm or less, may be 1.0 µm or less, or may be 150 nm or less.

The thickness of each layer, the dimensions of each constituent element, the intervals therebetween, and the like are measured by observing an image of a cross-section of the mask 20 using a scanning electron microscope.

Next, the second surface 402 of the mask layer 40 will be described. The second surface 402 faces the first surface 111 of the substrate 110 during the vapor deposition step. The second surface 402 may be in contact with the first surface 111 of the substrate 110 during the vapor deposition step.

When there is a gap between the second surface 402 of the mask layer 40 and the first surface 111 of the substrate 110, the vapor deposition material 7 enters the gap between the mask 20 and the substrate 110. When the vapor deposition material enters the gap, the shape of the vapor deposition layer deviates from an ideal shape. For example, the outline of the vapor deposition layer partially deviates from the ideal line. For example, the thickness of the vapor deposition layer in the outline portion of the vapor deposition layer partially deviates from the ideal thickness.

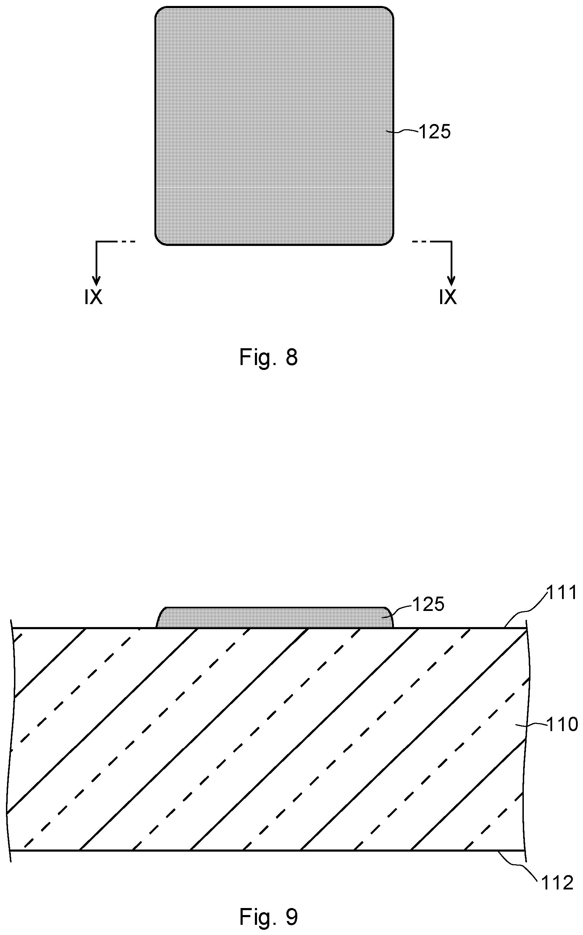

Fig. 8 is a plan view showing an example of a vapor deposition layer 125 having an ideal shape. The outline of the vapor deposition layer 125 includes, for example, a side extending linearly. Fig. 9 is a cross-sectional view of the vapor deposition layer 125 of Fig. 8 taken along the line IX-IX. The line IX-IX extends parallel to and in proximity to a side of the outline of the vapor deposition layer 125 in Fig. 8. The vapor deposition layer 125 has a uniform thickness regardless of the position.

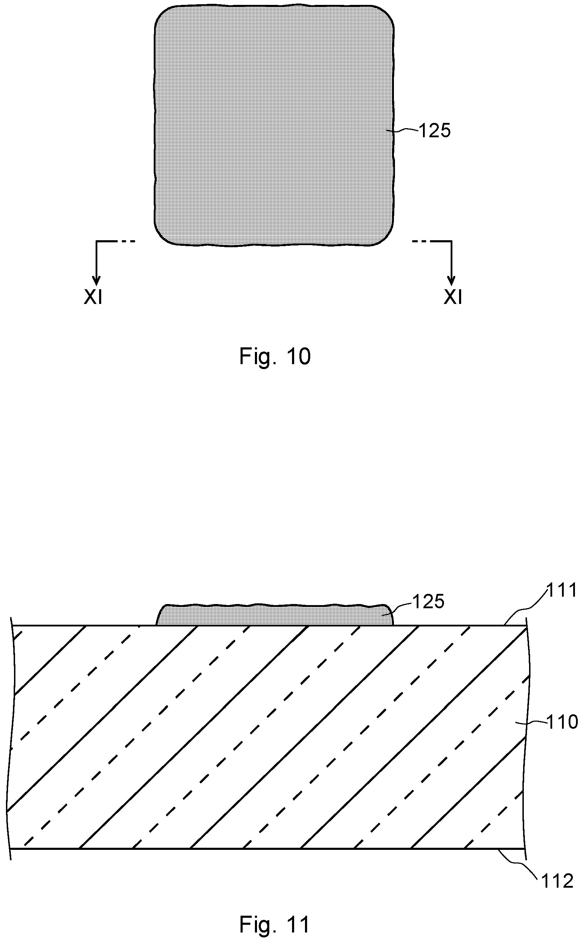

Fig. 10 is a plan view showing an example of the vapor deposition layer 125 having a shape deviating from an ideal shape. The outline of the vapor deposition layer 125 includes, for example, jagged sides like saw teeth. Fig. 11 is a cross-sectional view taken along line XI-XI of the vapor deposition layer 125 of Fig. 10. The line XI-XI extends substantially parallel to and in proximity to a side of the outline of the vapor deposition layer 125 in Fig. 10. The vapor deposition layer 125 has a thickness that varies depending on the position.

In order to suppress the vapor deposition material from entering the gap, and in order to suppress shadowing, it is preferable that the second surface 402 of the mask layer 40 has high adhesiveness to the first surface 111 of the substrate 110. In the present embodiment, it is proposed to control the surface roughness of the second surface 402 of the mask layer 40. As the surface roughness of the second surface 402 increases, the adhesiveness of the mask layer 40 to the substrate 110 is expected to decrease. By reducing the surface roughness of the second surface 402, the adhesiveness of the mask layer 40 to the substrate 110 is enhanced.

As an index of the surface roughness, the arithmetic mean roughness and the maximum height are known. Both the arithmetic mean roughness and the maximum height are calculated based on data indicating changes in the height of the surface of the second surface 402. Data indicating changes in the height of the surface is acquired by a laser microscope.

The arithmetic mean roughness is an average value of absolute values of differences between an average value of the heights and the heights at the respective positions of the second surface. As the arithmetic mean roughness, the arithmetic mean roughness Ra relating to line roughness and the arithmetic mean roughness Sa relating to surface roughness are known. The arithmetic mean roughness Ra is calculated based on data of the height of the surface of the second surface 402 measured at each position of a straight line having a predetermined measurement length. The arithmetic mean roughness Sa is calculated based on data of the height of the surface of the second surface 402 measured at each position in a region having a predetermined measurement area.

The maximum height is the difference between the maximum value and the minimum value among the heights at the respective positions of the second surface 402. As the maximum height, the maximum height Rz relating to line roughness and the maximum height Sz relating to surface roughness are known. The maximum height Rz is calculated based on data of the height of the surface of the second surface 402 measured at each position of a straight line having a predetermined measurement length. The maximum height Sz is calculated based on data of the height of the surface of the second surface 402 measured at each position in a region having a predetermined measurement area.

The second surface 402 of the first regions 41 of the mask layer 40 has a first arithmetic mean roughness Ra1, a first maximum height Rz1, a first arithmetic mean roughness Sa1, and a first maximum height Sz1. The first arithmetic mean roughness Ra1 is calculated by averaging the measurement results of the arithmetic mean roughness Ra at 25 points on the second surface 402 of the first regions 41. The first maximum height Rz1 is calculated by averaging the measurement results of the maximum height Rz at the 25 points on the second surface 402 of the first regions 41. The first arithmetic mean roughness Sa1 is calculated by averaging the measurement results of the arithmetic mean roughness Sa at the 25 points on the second surface 402 of the first regions 41. The first maximum height Sz1 is calculated by averaging the measurement results of the maximum height Sz at the 25 points on the second surface 402 of the first regions 41.

The second surface 402 of the second region 42 of the mask layer 40 has a second arithmetic mean roughness Ra2, a second maximum height Rz2, a second arithmetic mean roughness Sa2, and a second maximum height Sz2. The second arithmetic mean roughness Ra2 is calculated by averaging the measurement results of the arithmetic mean roughness Ra at 25 points on the second surface 402 of the second region 42. The second maximum height Rz2 is calculated by averaging the measurement results of the maximum height Rz at the 25 points on the second surface 402 of the second region 42. The second arithmetic mean roughness Sa2 is calculated by averaging the measurement results of the arithmetic mean roughness Sa at the 25 points on the second surface 402 of the second region 42. The second maximum height Sz2 is calculated by averaging the measurement results of the maximum height Sz at the 25 points on the second surface 402 of the second region 42.

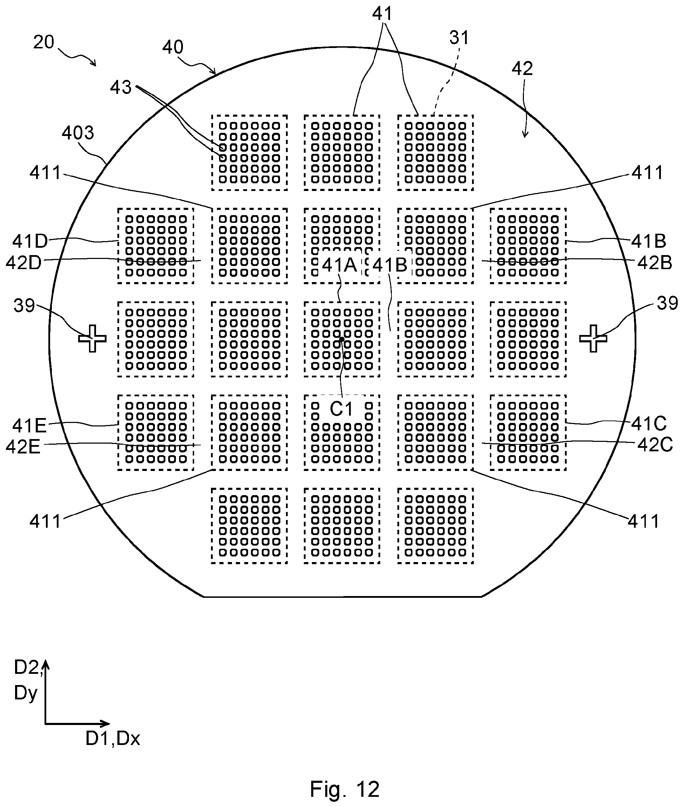

Fig. 12 is a plan view showing the measurement region of the mask layer 40. In the five first regions 41 and at five portions in the second region 42, the arithmetic mean roughness Ra and the maximum height Rz relating to the line roughness, and the arithmetic mean roughness Sa and the maximum height Sz relating to the surface roughness are measured. The five portions in the second region 42 are five twenty-first regions 421.

The five first regions 41 include a first region 41A to a first region 41E. The first region 41A is the first region 41 that overlaps the center point C1 of the mask 20 or is closest to the center point C1. The first region 41B is one of the outer first regions 412. The first region 41B is adjacent to the inner first region 411 in the first direction D1. The first region 41C is the outer first region 412 at a position line-symmetrical to the first region 41B with respect to a straight line extending in the first direction D1 and passing through the center point C1, or the outer first region 412 closest to the line-symmetrical position. The first region 41D is the outer first region 412 at a position line-symmetrical to the first region 41B with respect to a straight line extending in the second direction D2 and passing through the center point C1, or the outer first region 412 closest to the line-symmetrical position. The first region 41E is the outer first region 412 at a position point-symmetrical to the first region 41B with respect to the center point C1, or the outer first region 412 closest to the point-symmetrical position.

The five portions in the second region 42 include a second region 42A to a second region 42E. The second region 42A is a twenty-first region 421 adjacent to the first region 41A. The distance from the second region 42A to the first region 41B is shorter than the distance from the second region 42A to the first region 41D. The second region 42B is a twenty-first region 421 adjacent to the first region 41B and the inner first region 411. The second region 42C is a twenty-first region 421 adjacent to the first region 41C and the inner first region 411. The second region 42D is a twenty-first region 421 adjacent to the first region 41D and the inner first region 411. The second region 42E is a twenty-first region 421 adjacent to the first region 41E and the inner first region 411.

In each of the first region 41A to the first region 41E, the arithmetic mean roughness Ra, the maximum height Rz, the arithmetic mean roughness Sa, and the maximum height Sz are measured at five points. In each of the second region 42A to the second region 42E, the arithmetic mean roughness Ra, the maximum height Rz, the arithmetic mean roughness Sa, and the maximum height Sz are measured at five points.

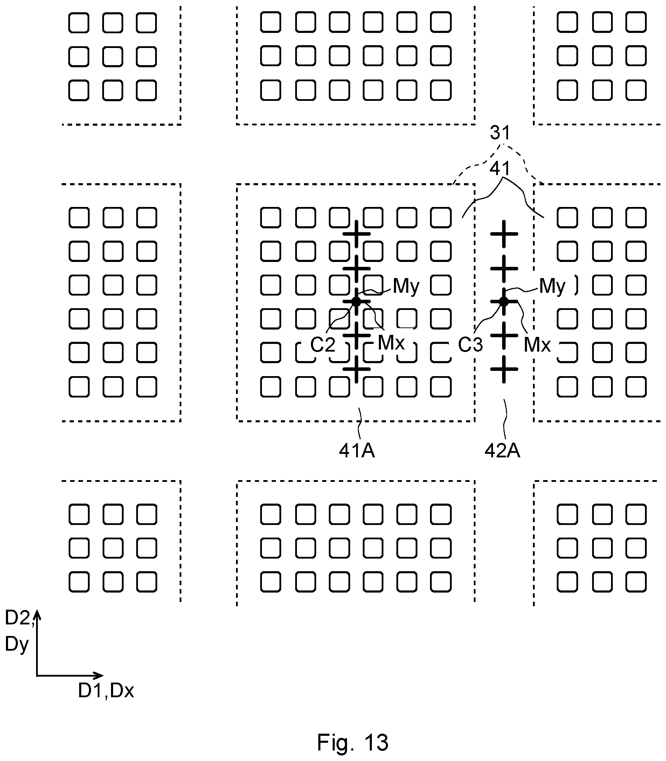

Fig. 13 is a view showing the measurement positions of the arithmetic mean roughness Ra and the maximum height Rz in the first region 41A and the second region 42A.

The straight lines extending in the x direction Dx and denoted by the reference sign Mx represent the measurement length of the arithmetic mean roughness Ra and the maximum height Rz in the x direction Dx. The measurement length of the straight lines Mx is 85 µm. The arithmetic mean roughness Ra and the maximum height Rz in the x direction Dx are calculated based on the data of the height of the surface of the second surface 402 along the straight lines Mx.

The straight lines extending in the y direction Dy and denoted by the reference sign My represent the measurement length of the arithmetic mean roughness Ra and the maximum height Rz in the y direction Dy. The measurement length of the straight lines My is 85 µm. The arithmetic mean roughness Ra and the maximum height Rz in the y direction Dy are calculated based on the data of the height of the surface of the second surface 402 along the straight lines My.

As shown in Fig. 13, the arithmetic mean roughness Ra and the maximum height Rz are measured at five positions in the first region 41A. Data of the height of the surface of the second surface 402 is acquired along the straight line Mx and the straight line My at each of the five points. The five points in the first region 41A are arranged in the y direction Dy with reference to the center point C2 of the first region 41A in plan view.

As shown in Fig. 13, the arithmetic mean roughness Ra and the maximum height Rz are measured at five points in the second region 42A. Data of the height of the surface of the second surface 402 is acquired along the straight line Mx and the straight line My at each of the five points. The five points in the second region 42A are arranged in the y direction Dy with reference to the center point C3 of the second region 42A in plan view.

The measurement positions of the arithmetic mean roughness Ra and the maximum height Rz in the first region 41B to the first region 41E are identical to the measurement positions of the arithmetic mean roughness Ra and the maximum height Rz in the first region 41A. The measurement positions of the arithmetic mean roughness Ra and the maximum height Rz in the second region 42B to the second region 42E are identical to the measurement positions of the arithmetic mean roughness Ra and the maximum height Rz in the second region 42A.

The first arithmetic mean roughness Ra1 described above is calculated by averaging the arithmetic mean roughness Ra in the x direction Dx at the 25 points on the second surface 402 of the first regions 41 and the arithmetic mean roughness Ra in the y direction Dy at the 25 points on the second surface 402 of the first regions 41. The first maximum height Rz1 described above is calculated by averaging the maximum height Rz in the x direction Dx at the 25 points on the second surface 402 of the first regions 41 and the maximum height Rz in the y direction Dy at the 25 points on the second surface 402 of the first regions 41.

Preferably, the deviation between the arithmetic mean roughness Ra in the x direction Dx and the arithmetic mean roughness Ra in the y direction Dy is 0.50 or less. The deviation is the ratio of the difference between the average of the arithmetic mean roughnesses Ra in the x direction Dx at the 25 points and the average of the arithmetic mean roughnesses Ra in the y direction Dy at the 25 points to the first arithmetic mean roughness Ra1. The deviation may be 0.40 or less, 0.30 or less, 0.20 or less, or 0.10 or less.

The above-described second arithmetic mean roughness Ra2 is calculated by averaging the arithmetic mean roughness Ra in the x direction Dx at the 25 points on the second surface 402 of the second region 42 and the arithmetic mean roughness Ra in the y direction Dy at the 25 points on the second surface 402 of the second region 42. The above-described second maximum height Rz2 is calculated by averaging the maximum height Rz in the x direction Dx at the 25 points on the second surface 402 of the second region 42 and the maximum height Rz in the y direction Dy at the 25 points on the second surface 402 of the second region 42.

Preferably, the first arithmetic mean roughness Ra1 is greater than the second arithmetic mean roughness Ra2. As a result, the adhesiveness of the first regions 41 to the substrate 110 is lower than the adhesiveness of the second region 42 to the substrate 110. In the separation step, the first regions 41 can be separated from the substrate 110 earlier than the second region 42. Since the stress applied to the first regions 41 is reduced, damage to the first regions 41 can be suppressed.

The difference (Ra1 - Ra2) between the first arithmetic mean roughness Ra1 and the second arithmetic mean roughness Ra2 is, for example, 0.5 nm or more, and may be 1.0 nm or more, 2.0 nm or more, or 3.0 nm or more. The (Ra1 - Ra2) is, for example, 10.0 nm or less, and may be 8.0 nm or less, 6.0 nm or less, or 5.0 nm or less.

The first arithmetic mean roughness Ra1 is, for example, 50 nm or less, may be 40 nm or less, may be 30 nm or less, or may be 25 nm or less. When the first arithmetic mean roughness Ra1 is 50 nm or less, interatomic forces act easily between the first regions 41 and the substrate 110. As a result, since the adhesiveness of the first regions 41 to the substrate 110 is increased, the gap between the first regions 41 and the substrate 110 can be suppressed. The first arithmetic mean roughness Ra1 is, for example, 1.0 nm or more, may be 3.0 nm or more, may be 5.0 nm or more, or may be 10 nm or more.

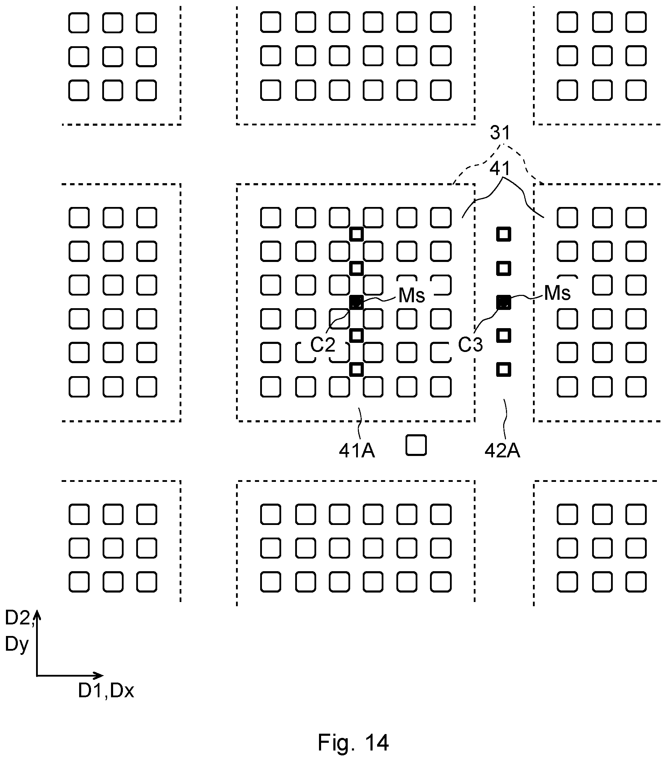

Fig. 14 is a view showing the measurement positions of the arithmetic mean roughness Sa and the maximum height Sz in the first region 41A and the second region 42A.

The quadrangles with the reference sign Ms represent the measurement area of the arithmetic mean roughness Sa and the maximum height Sz. The measurement area of such a quadrangle Ms is 6617.838 µm² (70.44 µm × 93.95 µm). The arithmetic mean roughness Sa and the maximum height Sz are calculated based on the height data of the surface of the second surface 402 measured at multiple positions within the quadrangle Ms.

As shown in Fig. 14, the arithmetic mean roughness Sa and the maximum height Sz are measured at five points in the first region 41A. The five points in the first region 41A are arranged in the y direction Dy with reference to the center point C2 of the first region 41A in plan view.

As shown in Fig. 14, the arithmetic mean roughness Sa and the maximum height Sz are measured at five points in the second region 42A. For the five points, the five points in the second region 42A are arranged in the y direction Dy with reference to the center point C3 of the second region 42A in plan view.

The measurement positions of the arithmetic mean roughness Sa and the maximum height Sz in the first region 41B to the first region 41E are the same as the measurement positions of the arithmetic mean roughness Sa and the maximum height Sz in the first region 41A. The measurement positions of the arithmetic mean roughness Sa and the maximum height Sz in the second region 42B to the second region 42E are the same as the measurement positions of the arithmetic mean roughness Sa and the maximum height Sz in the second region 42A.

The above-mentioned first arithmetic mean roughness Sa1 is calculated by averaging the arithmetic mean roughness Sa at the 25 points on the second surface 402 of the first regions 41. The above-mentioned first maximum height Sz1 is calculated by averaging the maximum height Sz at the 25 points on the second surface 402 of the first regions 41.

The above-mentioned second arithmetic mean roughness Sa2 is calculated by averaging the arithmetic mean roughness Sa at the 25 points on the second surface 402 of the second region 42. The above-mentioned second maximum height Sz2 is calculated by averaging the maximum height Sz at the 25 points on the second surface 402 of the second region 42.

The first arithmetic mean roughness Sa1 is, for example, 70 nm or less, and may be 60 nm or less, 50 nm or less, or 40 nm or less. When the first arithmetic mean roughness Sa1 is70 nm or less, the gap between the first regions 41 and the substrate 110 can be suppressed. The first arithmetic mean roughness Sa1 is, for example, 2.0 nm or more, may be 4.0 nm or more, may be 6.0 nm or more, or may be 12 nm or more.

It is preferable that Sa1/Ra1, which is the ratio of the first arithmetic mean roughness Sa1 to the first arithmetic mean roughness Ra1, is appropriately controlled. As shown in the Examples described later, even when the first arithmetic mean roughness Ra1 and the first arithmetic mean roughness Sa1 are small, the shape of the vapor deposition layer may deviate from an ideal shape if Sa1/Ra1 is large. For example, the outline of the vapor deposition layer sometimes appears blurred. By appropriately controlling Sa1/Ra1, the shape of the vapor deposition layer can be appropriately controlled.

A large Sa1/Ra1 means that the variation in the surface roughness of the second surface 402 in the in-plane direction of the second surface 402 of the first regions 41 is large. By appropriately controlling Sa1/Ra1, it is possible to suppress the variation in the surface roughness of the second surface 402 in the in-plane direction of the second surface 402 of the first regions 41. Therefore, the shape of the vapor deposition layer can be made closer to an ideal shape.

Sa1/Ra1, which is the ratio of the first arithmetic mean roughness Sa1 to the first arithmetic mean roughness Ra1, is, for example, 1.82 or less, may be 1.70 or less, may be 1.60 or less, may be 1.50 or less, or may be 1.40 or less. The Sa1/Ra1 is, for example, 1.05 or more, may be 1.10 or more, may be 1.20 or more, or may be 1.30 or more.

Preferably, the first arithmetic mean roughness Sa1 is greater than the second arithmetic mean roughness Sa2. As a result, the adhesiveness of the first regions 41 to the substrate 110 is lower than the adhesiveness of the second region 42 to the substrate 110.

The difference (Sa1 - Sa2) between the first arithmetic mean roughness Sa1 and the second arithmetic mean roughness Sa2 is, for example, 0.5 nm or more, and may be 1.0 nm or more, 2.0 nm or more, or 3.0 nm or more. The (Sa1 - Sa2) is, for example, 10.0 nm or less, and may be 8.0 nm or less, 6.0 nm or less, or 5.0 nm or less.

The first maximum height Sz1 is, for example, 1000 nm or less, and may be 700 nm or less, 500 nm or less, 300 nm or less, or 200 nm or less. When the first maximum height Sz1 is 1000 nm or less, interatomic forces act easily between the first regions 41 and the substrate 110. As a result, since the adhesiveness of the first regions 41 to the substrate 110 is increased, the gap between the first regions 41 and the substrate 110 can be suppressed. The first maximum height Sz1 is, for example, 10 nm or more, and may be 30 nm or more, 50 nm or more, or 100 nm or more.

The first maximum height Sz1 may be smaller than the second maximum height Sz2. The difference between the first maximum height Sz1 and the second maximum height Sz2 (Sz2 - Sz1) is, for example, 100 nm or more, may be 200 nm or more, or may be 250 nm or more. The (Sz2 - Sz1) is, for example, 500 nm or less, may be 450 nm or less, or may be 400 nm or less.

Next, the method for manufacturing the mask 20 will be described. First, a base material preparation step of preparing the base material 30 is performed. A silicon wafer may be used as the base material 30. The base material first surface 301 and the base material second surface 302 of the base material 30 may be mirror-polished. The arithmetic mean roughness Ra of the base material first surface 301 and the base material second surface 302 may be 1.5 nm or less, or may be 1.0 nm or less. The plane orientation of the base material first surface 301 and the base material second surface 302 may be (100), (110), or the like.

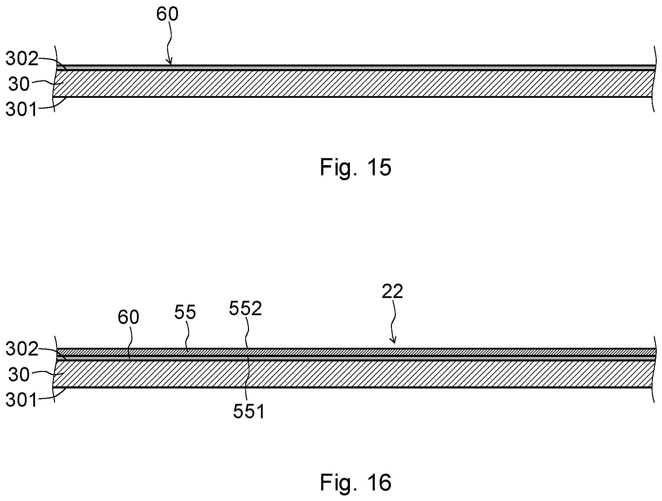

Subsequently, an intermediate layer forming step is performed. In the intermediate layer forming step, as shown in Fig. 15, the intermediate layer 60 is formed on the base material second surface 302 of the base material 30. The intermediate layer 60 includes, for example, a stopper layer 61. The intermediate layer 60 may include the stopper layer 61 and a seed layer 62. The intermediate layer 60 may be formed on the entire base material second surface 302. The intermediate layer 60 may be formed by, for example, a physical film formation method such as a sputtering method, a vapor deposition method, or an ion plating method.

Subsequently, as shown in Fig. 16, an insulating layer forming step of forming the insulating layer 55 on the intermediate layer 60 is performed. The insulating layer 55 may be formed on the entire base material second surface 302.

The insulating layer 55 is, for example, a resist layer. The insulating layer forming step may include a step of attaching a dry film resist to the intermediate layer 60. The insulating layer forming step may include a step of applying a solution containing a resist material onto the intermediate layer 60. The resist layer may contain a positive resist material or a negative resist material.

The insulating layer 55 may contain a silicon compound. The silicon compound may be formed by a chemical vapor deposition method. For example, the insulating layer 55 may be formed by a chemical vapor deposition method using tetraethyl silicate Si(OC₂H₅)₄ as a raw material. Tetraethyl silicate is also referred to as TEOS.

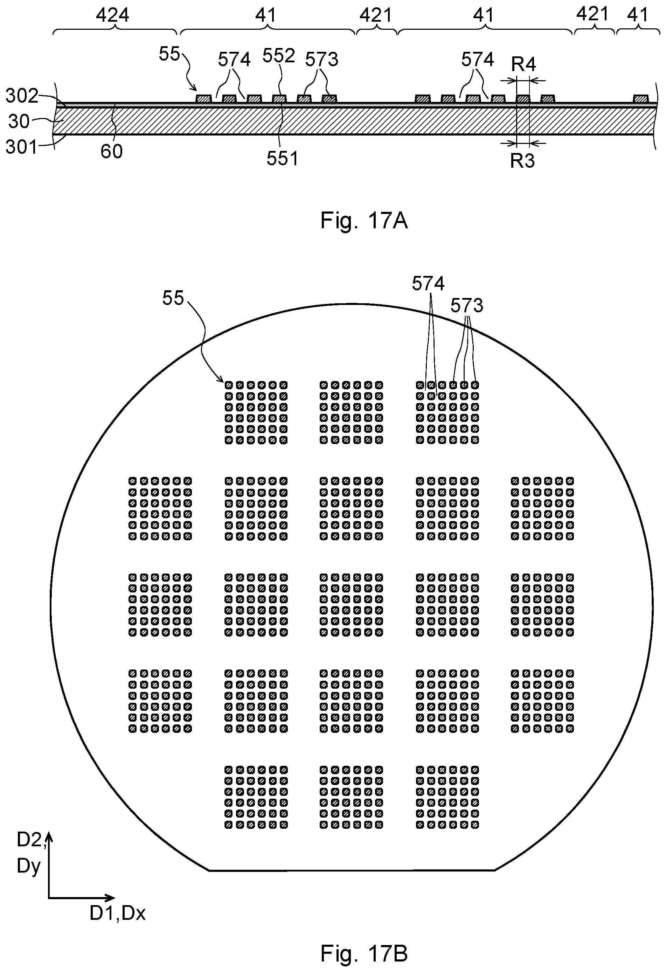

The insulating layer forming step may include an insulating layer processing step of processing the insulating layer 55. Figs. 17A and 17B are a cross-sectional view and a plan view showing the processed insulating layer 55. The insulating layer 55 includes an insulating first surface 551 facing the base material second surface 302 of the base material 30 and an insulating second surface 552 located on the side opposite to the insulating first surface 551.

The insulating layer 55 includes a plurality of island portions 573. The above-described second openings 43 of the mask 20 are formed at the positions of the island portions 573.

The reference sign R3 represents the size of the island portion 573 on the insulating first surface 551. The reference sign R4 represents the size of the island portion 573 on the insulating second surface 552. The size R3 is also referred to as the third size. The size R4 is also referred to as the fourth size. The fourth size R4 may be smaller than the third size R3. As a result, the second size R2 of the second opening 43 can be made smaller than the first size R1. The third size R3 and the fourth size R4 are determined in the directions in which the island portions 573 are arranged.

The method of processing the insulating layer 55 is not particularly limited. For example, when the insulating layer 55 is a resist layer, the insulating layer 55 may be processed by exposing and developing the insulating layer 55. For example, when the insulating layer 55 contains a silicon compound, the insulating layer 55 may be processed by dry etching using an etching gas. The dry etching may be reactive ion etching.

Subsequently, a metal layer forming step of forming the metal layer 50 is performed. In the present embodiment, the metal layer 50 is formed between the plurality of island portions 573 shown in Figs. 17A and 17B, that is, in gaps 574. The metal layer 50 is also formed outside the plurality of island portions 573.

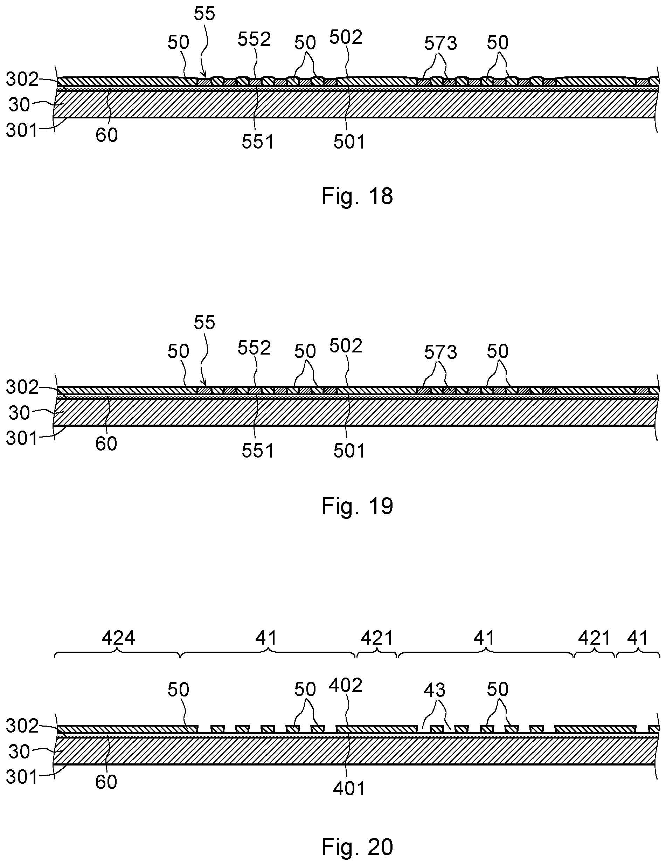

Fig. 18 is a cross-sectional view showing the metal layer 50 formed by the metal layer forming step. The metal layer forming step may include a plating step. That is, the metal layer 50 may be formed by the plating step. In the plating step, a plating solution containing ions of the metal constituting the metal layer 50 is supplied onto the intermediate layer 60. The plating step may be an electrolytic plating step or an electroless plating step. When the electrolytic plating step is performed, the intermediate layer 60 includes a seed layer 62.

When the plating step is an electrolytic plating step, Sa1/Ra1 on the second surface 402 of the first regions 41 can be controlled by controlling the current density of the intermediate layer 60. For example, as the current density decreases, Sa1/Ra1 on the second surface 402 of the first regions 41 tends to decrease.

The metal layer 50 includes a metal first surface 501 facing the base material second surface 302 of the base material 30 and a metal second surface 502 located on the side opposite to the metal first surface 501. The metal layer 50 is in contact with the wall surfaces of the island portions 573 in the plane direction of the base material first surface 301 of the base material 30. The metal layer 50 is in contact with the intermediate layer 60 in the thickness direction of the base material 30. As shown in Fig. 18, the metal layer 50 may protrude beyond the insulating layer 55 in the thickness direction of the base material 30. That is, the metal second surface 502 of the metal layer 50 may be located above the insulating second surface 552 of the insulating layer 55. The metal layer 50 may not be formed on the insulating second surface 552 of the insulating layer 55.

The metal layer forming step may include a sputtering step. That is, the metal layer 50 may be formed by a sputtering step. In this case, the metal layer 50 may be formed between the plurality of island portions 573 and on the insulating second surface 552 of the insulating layer 55.

The metal layer forming step may include an annealing step of heating the metal layer 50. By the annealing step, the strain generated inside the metal layer 50 can be reduced. In the annealing step, the base material 30, the metal layer 50, and the insulating layer 55 are held in an environment at a temperature higher than room temperature. The temperature of the annealing step is, for example, 120°C or more, may be 140°C or more, or may be 150°C or more. The temperature of the annealing step is, for example, 250°C or less, may be 220°C or less, or may be 200°C or less. When the metal layer 50 is a layer formed by plating and containing an alloy such as an iron-nickel alloy, the annealing step may be performed at a higher temperature. When recrystallization progresses by performing the annealing step on the alloy layer formed by plating, characteristics equivalent to those of the melted alloy can be realized. The characteristics are, for example, a thermal expansion coefficient, a Young's modulus, and hardness. The temperature of the annealing step performed on the alloy layer formed by plating is, for example, 400°C or more, may be 500°C or more, or may be 600°C or more.

Subsequently, a polishing step may be performed. In the polishing step, a portion of the metal layer 50 located above the insulating second surface 552 of the insulating layer 55 is polished. Fig. 19 is a cross-sectional view showing the polished metal layer 50.

In the polishing step, the metal layer 50 may be polished by chemical mechanical polishing. For example, the polishing step may include a step of bringing a slurry containing a working fluid and abrasive grains into contact with the object. The object is the insulating second surface 552 and the metal second surface 502. The object is polished by rotating the object relative to a polishing pad in a state in which the slurry is positioned between the polishing pad of the polishing tool and the object.

The working fluid may be an acidic solution or an alkaline solution. The abrasive grains may include inorganic oxide such as alumina, silica, or zirconia. The polishing pad may comprise polyurethane.

The polishing step may be adjusted such that the surface roughness of the metal second surface 502 of the metal layer 50 constituting the first regions 41 is greater than the surface roughness of the metal second surface 502 of the metal layer 50 constituting the second region 42. The metal layer 50 formed in the gaps 574 between the plurality of island portions 573 constitutes the first regions 41. The metal layer 50 formed outside the plurality of island portions 573 constitutes the second region 42.

In the polishing of the metal layer 50 constituting the first regions 41, the polishing pad comes into contact with the plurality of island portions 573 and the metal layer 50 located in the gaps 574 therebetween. On the other hand, in the polishing of the metal layer 50 constituting the second region 42, most of the polishing pad is in contact with the metal layer 50 that continuously spreads. Therefore, the fluidity of the slurry at the time of polishing the metal layer 50 constituting the first regions 41 is different from the fluidity of the slurry at the time of polishing the metal layer 50 constituting the second region 42. Due to the difference in fluidity of the slurry, a difference occurs between the surface roughness of the metal layer 50 constituting the first regions 41 and the surface roughness of the metal layer 50 constituting the second region 42.

The difference in surface roughness is controlled by adjusting the material of the polishing pad, the components of the slurry, the flow rate of the slurry, the polishing pressure, the rotational speed of the polishing pad, the rotational speed of the object, and the like. For example, as shown in the Examples described later, when the abrasive grains contain alumina, the surface roughness of the first regions 41 tends to be greater than the surface roughness of the second region 42. For example, the smaller the size of the abrasive grains, the more the surface roughness of the first regions 41 tends to be greater than the surface roughness of the second region 42.

The polishing step may be performed until the polishing pad of the polishing tool reaches the insulating second surface 552 of the insulating layer 55 in the thickness direction. As a result, the metal second surface 502 of the metal layer 50 is coplanar with the insulating second surface 552 of the insulating layer 55. "Coplanar" means that the height difference between the two surfaces is 1.0 µm or less. The height difference between the metal second surface 502 and the insulating second surface 552 may be 0.5 µm or less, 0.3 µm or less, 0.2 µm or less, or 0.1 µm or less.

Subsequently, as shown in Fig. 20, an insulating layer removing step of removing the insulating layer 55 is performed. In the insulating layer removing step, an etchant such as a buffered hydrofluoric acid solution is supplied toward the insulating layer 55. As a result, the plurality of island portions 573 are removed.

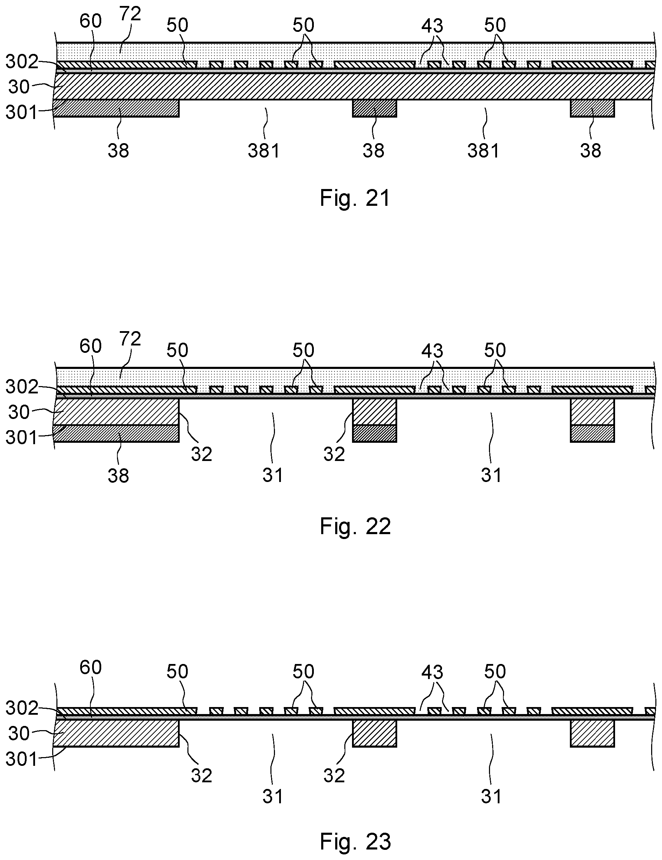

Subsequently, a base material processing step of forming the first openings 31 in the base material 30 is performed. In the base material processing step, as shown in Fig. 21, a resist layer 38 may be partially formed on the base material first surface 301. The resist layer 38 has resist openings 381 corresponding to the first openings 31. As shown in Fig. 21, a protective layer 72 covering the metal layer 50 may be formed.

The resist layer 38 may be a photoresist. In this case, first, the resist layer 38 is formed on the base material first surface 301 by coating the base material first surface 301 with liquid resist material. After the coating, a step of heating the resist layer 38 may be performed. Subsequently, the photolithography process of exposing and developing the resist layer 38 is performed. As a result, the resist openings 381 are formed in the resist layer 38.

Although not shown, the resist layer 38 may be a silicon oxide film partially formed on the base material first surface 301. The silicon oxide film is formed, for example, by partially performing a thermal oxidation treatment or the like on the base material first surface 301. The silicon oxide film may be formed on the base material 30 before the intermediate layer 60 is formed on the base material 30.

In the base material processing step, as shown in Fig. 22, the first openings 31 are formed in the base material 30 by etching the base material 30 from the base material first surface 301 side. The etching may be dry etching using an etching gas. Since the intermediate layer 60 has resistance to the etchant, as shown in Fig. 22, progress of the etching to the metal layer 50 is suppressed. The etching gas is, for example, SF₆ gas.

Subsequently, a resist removing step of removing the resist layer 38, a protective layer removing step of removing the protective layer 72, and an intermediate layer removing step of removing the intermediate layer 60 are performed. The order of the resist removing step, the protective layer removing step, and the intermediate layer removing step is not particularly limited. Fig. 23 is a cross-sectional view showing a state where the resist removing step and the protective layer removing step have been performed. Two or three of the resist removing step, the protective layer removing step, and the intermediate layer removing step may be performed simultaneously.

When the resist layer 38 is a photoresist, a resist processing liquid containing N-methyl-2-pyrrolidone may be supplied toward the resist layer 38. The resist layer 38 may be removed by irradiating the resist layer 38 with oxygen plasma. When the resist layer 38 is a silicon oxide film, a resist processing liquid containing hydrofluoric acid may be supplied toward the resist layer 38. The resist layer 38 may be removed by dry etching using a CF₄ gas or the like.

Removal of the intermediate layer 60 is carried out by supplying an etchant for the intermediate layer 60 to the first openings 31. As a result, the intermediate layer 60 overlapping the first openings 31 in plan view is removed. Removal of the intermediate layer 60 may be performed by dry etching using a fluorine-based gas or the like. The intermediate layer 60 may be removed by wet etching using an acidic etching solution.

The mask 20 shown in Figs. 3A to 5 is obtained by removing the resist layer 38, the protective layer 72, and the intermediate layer 60 overlapping the first openings 31.

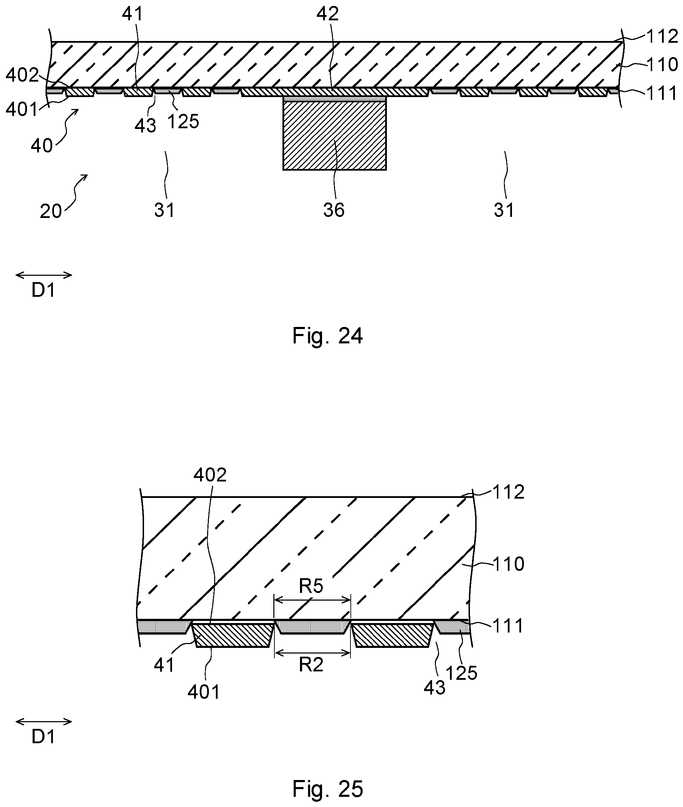

Next, a method for manufacturing a device using the mask 20 will be described. The manufacturing method includes a vapor deposition step of forming a vapor deposition layer on the first surface 111 of the substrate 110 using the mask 20. Fig. 24 is a cross-sectional view showing an example of the vapor deposition step. The vapor deposition material that has passed through the second openings 43 of the mask layer 40 adheres to the first surface 111, thereby forming the vapor deposition layer 125. The vapor deposition layer 125 is, for example, the organic layer 130. The vapor deposition layer 125 may be the second electrode 140.

Fig. 25 is a cross-sectional view showing the vapor deposition layer 125. The vapor deposition layer 125 has a size R5 in the first direction D1. The size R5 is measured along a cut surface that extends in the first direction D1 and passes through the midpoints of the outer edges of the second opening 43, which extends in the second direction D2 orthogonal to the first direction D1.

The vapor deposition layer 125 includes a portion formed by the vapor deposition material that has entered the gap between the second surface 402 of the mask layer 40 and the first surface 111 of the substrate 110. Therefore, the size R5 of the vapor deposition layer 125 is greater than the size R2 of the second opening 43 in the second surface 402. The shadowing is quantitatively evaluated based on the difference between the size R5 and the size R2. In the present application, a value obtained by dividing the difference between the size R5 and the size R2 by 2, that is, (R5 - R2)/2 is referred to as the shadowing amount.

The second surface 402 of the first regions 41 of the mask layer 40 has a first arithmetic mean roughness Ra1 equal to or less than 50 nm and a first maximum height Sz1 equal to or less than 1000 nm. Since the gap between the second surface 402 and the first surface 111 is reduced, the shadowing amount is reduced. The shadowing amount is, for example, 0.10 µm or less, and may be 0.08 µm or less, 0.06 µm or less, or 0.04 µm or less.

The sizes of the mask 20, such as sizes R1 to R4, are measured by observing a cross section of the mask 20 using a scanning electron microscope. Such a size is calculated by averaging the measurement results at the positions corresponding to ten second openings 43. The ten second openings 43 are extracted from the first region 41 closest to the center point C1 of the mask 20. The ten second openings 43 include the second opening 43 closest to the center point C2 of the first region 41 in plan view.

The size R5 of the vapor deposition layer 125 is measured by observing the vapor deposition layer 125 using an atomic force microscope.

In the second surface 402 of the first regions 41 of the mask layer 40, Sa1/Ra1, which is a ratio of the first arithmetic mean roughness Sa1 to the first arithmetic mean roughness Ra1, is 1.82 or less. By reducing Sa1/Ra1, variation in the surface roughness of the second surface 402 in the in-plane direction of the second surface 402 of the first regions 41 is suppressed. Therefore, the shape of the vapor deposition layer 125 can be made closer to an ideal shape.

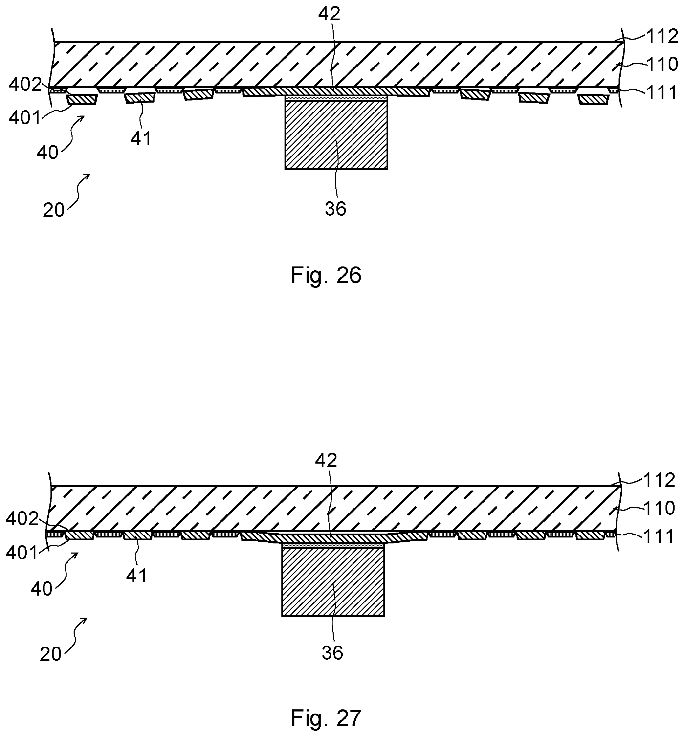

After the vapor deposition step, a separation step of separating the substrate 110 from the mask 20 is performed. Fig. 26 is a cross-sectional view showing an example of the separation step. In the separation step, the substrate 110 is separated from the mask 20 by moving the substrate 110 relative to the mask 20. The separation step may include a step of moving the magnet 5 shown in Fig. 2 away from the mask 20. The decrease in the magnetic force facilitates the separation of the mask 20 from the substrate 110.

The first arithmetic mean roughness Ra1 of the second surface 402 of the first regions 41 is greater than the second arithmetic mean roughness Ra2 of the second surface 402 of the second region 42. Therefore, as shown in Fig. 26, in the separation step, the first regions 41 are separated from the substrate 110 earlier than the second region 42. Since the stress applied to the first regions 41 is reduced, damage to the first regions 41 is suppressed.

Fig. 27 is a cross-sectional view showing a separation step in a comparative embodiment. In the comparative embodiment, the surface roughness of the first regions 41 of the mask 20 is smaller than the surface roughness of the second region 42. As a result, the adhesiveness of the first regions 41 to the substrate 110 is higher than the adhesiveness of the second region 42 to the substrate 110. In this case, as shown in Fig. 27, in the separation step, the second region 42 may be separated from the substrate 110 earlier than the first regions 41. A large stress is applied to the portion of the first regions 41 that is in contact with the substrate 110 until the end of the separation step. Therefore, damage is likely to occur in the first regions 41. It is also conceivable that damage occurs in the vapor deposition layer 125 that is in contact with the first regions 41 or located near the first regions 41.

On the other hand, in the present embodiment, since the first regions 41 are separated from the substrate 110 earlier than the second region 42, damage to the first regions 41 and the vapor deposition layer 125 is suppressed.

The above-described embodiment can be modified in various ways. Hereinafter, the modifications will be described with reference to the drawings as necessary. In the following description and the drawings used in the following description, parts that can be configured similarly to the above-described embodiment are denoted by the same reference signs as those used for the corresponding parts in the above-described embodiment. Overlapping descriptions will be omitted. In addition, in a case where it is apparent that the operational effects obtained in the above-described embodiment can also be obtained in the modifications, the description thereof may be omitted.

### (First Modification)

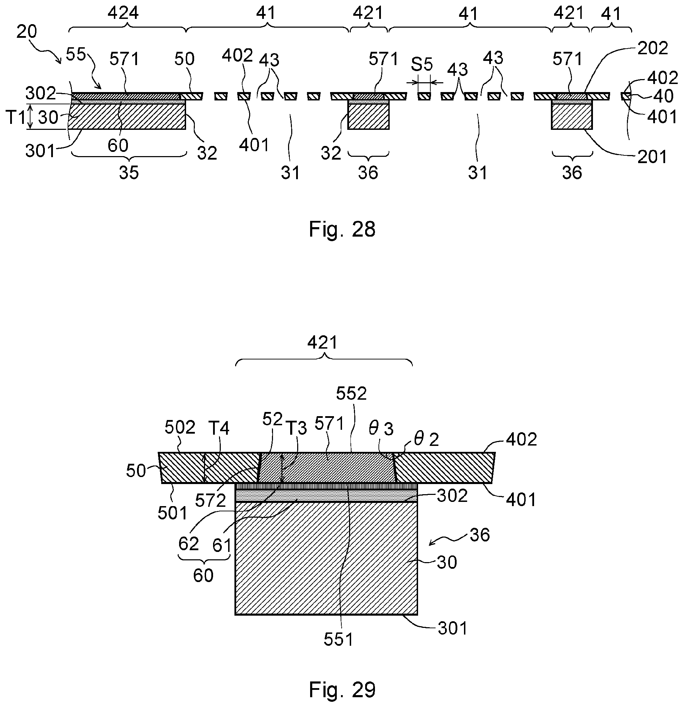

Fig. 28 is a cross-sectional view showing an example of a mask 20 in the first modification. The second region 42, such as the twenty-first region 421 and the twenty-fourth region 424, may include the insulating layer 55. Although not illustrated, the twenty-second region 422 and the twenty-third region 423 may also include the insulating layer 55. The insulating layer 55 located in the second region 42 is also referred to as a frame portion 571.

Fig. 29 is a cross-sectional view illustrating an example of a portion of the mask 20 corresponding to the twenty-first region 421 of the mask layer 40. The twenty-first region 421 may include the frame portion 571 of the insulating layer 55 and the metal layer 50 overlapping the inner region 36 in plan view. The intermediate layer 60 may be located between the base material 30 and a part of the metal layer 50 and the frame portion 571.

As shown in Fig. 29, the metal second surface 502 of the metal layer 50 and the insulating second surface 552 of the frame portion 571 may be coplanar. For example, at the boundary between the metal layer 50 and the frame portion 571, the height difference between the metal second surface 502 and the insulating second surface 552 may be 1.0 µm or less.

The thickness T3 of the insulating layer 55 is, for example, 25.0 µm or less, may be 10.0 µm or less, or may be 5.0 µm or less. The thickness T3 of the insulating layer 55 is, for example, 0.5 µm or more, may be 1.0 µm or more, or may be 2.0 µm or more. The thickness T3 of the insulating layer 55 may be equal to the thickness T4 of the metal layer 50. For example, the difference between the thicknesses T3 and T4 may be 1.0 µm or less.

As shown in Fig. 29, an insulating wall surface 572 of the frame portion 571 may be in contact with a metal outer wall surface 52 of the metal layer 50. In this case, the insulating wall surface 572 has a shape corresponding to the metal outer wall surface 52. For example, the sum of an angle θ2 and an angle θ3 may be 180°. The angle θ2 is the angle formed by the metal outer wall surface 52 and the metal second surface 502. The angle θ3 is the angle formed by the insulating wall surface 572 and the insulating second surface 552. The metal outer wall surface 52 may overlap the base material 30 in plan view. In other words, the metal outer wall surface 52 may not overlap the first openings 31 in plan view.

The angle θ2 is, for example, 50° or more, may be 55° or more, or may be 60° or more. The angle θ2 is, for example, less than 90°, may be 85° or less, or may be 80° or less.

The angle θ3 is, for example, more than 90°, may be 95° or more, or may be 100° or more. The angle θ3 is, for example, 130° or less, may be 125° or less, or may be 120° or less.

The material of the insulating layer 55 has insulating properties. For example, the insulating layer 55 contains a silicon compound that has insulating properties. The silicon compound is, for example, silicon oxide.

A method for manufacturing the mask 20 according to the first modification will be described. As in the case of the above-described embodiment, the base material preparation step, the intermediate layer forming step, and the insulating layer forming step are performed. In the insulating layer forming step, the insulating layer 55 may be formed by a chemical vapor deposition method. The insulating layer forming step may include an insulating layer processing step of processing the insulating layer 55.

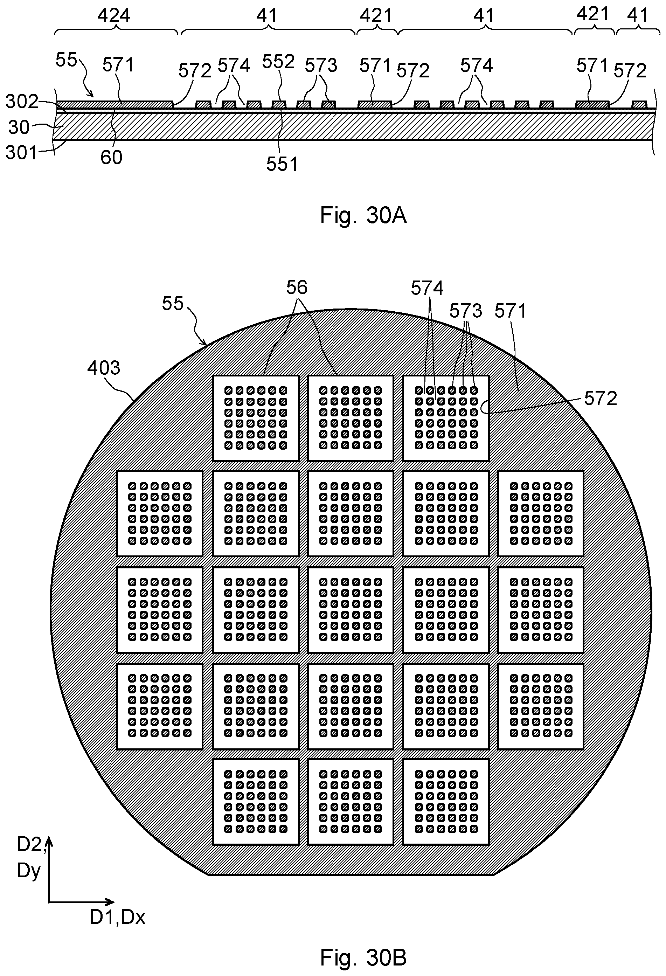

Figs. 30A and 30B are a cross-sectional view and a plan view showing the processed insulating layer 55. In the insulating layer processing step, a plurality of insulating openings 56 may be formed in the insulating layer 55. The plurality of insulating openings 56 may be arranged in the first direction D1 and the second direction D2. The plurality of insulating openings 56 have an outline corresponding to the metal layer 50 located in the first region 41 in plan view. As shown in Fig. 30B, the outlines of the insulating openings 56 may be rectangular. Although not shown, the corners of the outlines of the insulating openings 56 may be curved. The outlines of the insulating openings 56 may have other shapes such as a circular shape. The insulating openings 56 are configured such that the outlines of the insulating openings 56 surround the outlines of the first openings 31 to be formed in a later step. The shape of the outlines of the insulating openings 56 may be similar to the shape of the outlines of the first openings 31.

The insulating layer 55 includes the frame portion 571 that defines the outlines of the insulating openings 56. The frame portion 571 includes the insulating wall surfaces 572 that face and define the insulating openings 56. The insulating layer 55 includes the plurality of island portions 573 surrounded by the insulating openings 56 in plan view. The above-described second openings 43 of the mask 20 are formed at the positions of the island portions 573.

The method of processing the insulating layer 55 is not particularly limited. For example, the insulating layer 55 may be processed by dry etching using an etching gas. The dry etching may be reactive ion etching.

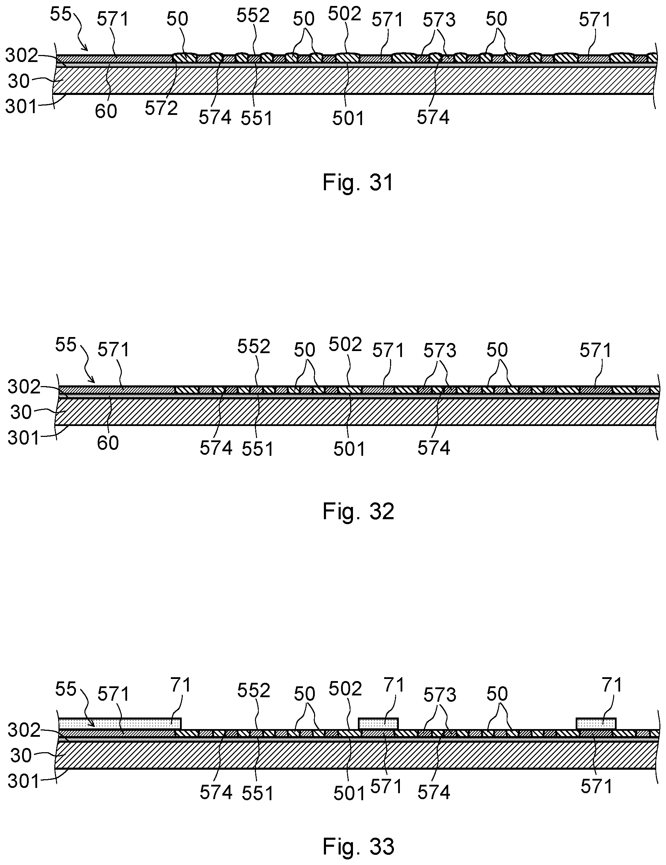

Subsequently, as shown in Fig. 31, a metal layer forming step of forming the metal layer 50 is performed. In this modification, the metal layer 50 is formed in the gaps 574 between the plurality of island portions 573 in the insulating openings 56. When the metal layer forming step includes an electrolytic plating step, a hole, a notch, or the like for supplying a current to the seed layer 62 may be formed in the frame portion 571 of the insulating layer 55.

Subsequently, a polishing step may be performed. In the polishing step, a portion of the metal layer 50 located above the insulating second surface 552 of the insulating layer 55 is polished. Fig. 32 is a cross-sectional view showing the polished metal layer 50.

The polishing step may be adjusted such that the surface roughness of the metal second surface 502 of the metal layer 50 constituting the first regions 41 is greater than the surface roughness of the insulating second surface 552 of the insulating layer 55 constituting the second region 42. The metal layer 50 formed in the gaps 574 between the plurality of island portions 573 constitutes the first regions 41. The frame portion 571 of the insulating layer 55 constitutes the twenty-first regions 421, the twenty-second regions 422, the twenty-third regions 423, and the twenty-fourth region 424 of the second region 42.

Subsequently, the insulating layer removing step of removing a part of the insulating layer 55 is performed. In the insulating layer removing step, as shown in Fig. 33, a protective layer 71 that covers the frame portion 571 of the insulating layer 55 may be formed. The protective layer 71 may not cover the plurality of island portions 573. The protective layer 71 may not cover the metal layer 50 surrounding the plurality of island portions 573.

In the insulating layer removing step, an etchant such as a buffered hydrofluoric acid solution is supplied toward the insulating layer 55. As a result, the plurality of island portions 573 that are not covered with the protective layer 71 are removed. After the island portions 573 are removed, a step of removing the protective layer 71 may be performed.

Subsequently, as in the case of the above-described embodiment, the base material processing step, the resist removing step, the protective layer removing step, and the intermediate layer removing step are performed. As a result, the mask 20 shown in Fig. 28 is obtained.

Also in this modification, the second surface 402 of the first regions 41 of the mask layer 40 has a first arithmetic mean roughness Ra1 of 50 nm or less and a first maximum height Sz1 of 1000 nm or less. Since the gap between the second surface 402 and the first surface 111 is reduced, the shadowing amount is reduced.

Also in this modification, Sa1/Ra1, which is a ratio of the first arithmetic mean roughness Sa1 to the first arithmetic mean roughness Ra1 on the second surface 402 of the first regions 41 of the mask layer 40, is 1.82 or less. By reducing Sa1/Ra1, the variation in the surface roughness of the second surface 402 in the in-plane direction of the second surface 402 of the first regions 41 is suppressed. Therefore, the shape of the vapor deposition layer 125 can be made closer to an ideal shape.

### (Second Modification)

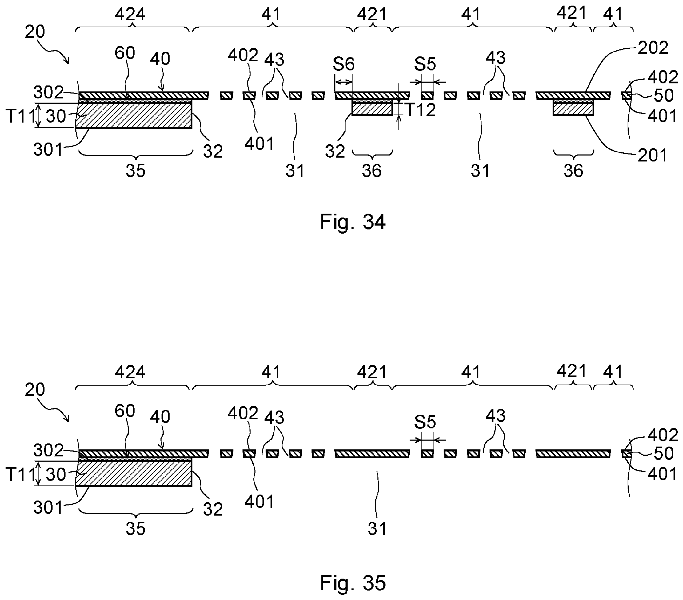

Fig. 34 is a cross-sectional view showing an example of a mask 20 in the second modification. The thickness T12 of the inner region 36 of the base material 30 may be smaller than the thickness T11 of the outer region 35.

The thickness T12 is, for example, 10 µm or more, may be 30 µm or more, or may be 50 µm or more. The thickness T12 is, for example, 300 µm or less, may be 200 µm or less, or may be 100 µm or less.

T12/T11, which is the ratio of the thickness T12 to the thickness T11, is, for example, 0.01 or more, may be 0.10 or more, or may be 0.20 or more. The T12/T11 is, for example, 0.90 or less, may be 0.70 or less, or may be 0.50 or less.

### (Third Modification)

Fig. 35 is a cross-sectional view showing an example of a mask 20 in the third modification. The base material 30 may not include the portion located between two first regions 41 adjacent in plan view. In other words, the twenty-first regions 421, the twenty-second regions 422, and the twenty-third regions 423 of the second region 42 may not be supported by the base material 30. The twenty-fourth region 424 of the second region 42 may be supported by the outer region 35 of the base material 30.

### (Fourth Modification)

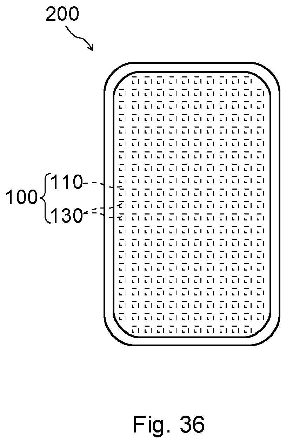

Fig. 36 is a view showing an example of an apparatus 200 comprising the device 100. The apparatus 200 includes the substrate 110 and a vapor deposition layer, such as the organic layer 130. The vapor deposition layer is a layer formed by a vapor deposition method using the mask 20. The apparatus 200 is, for example, a smartphone. The apparatus 200 may be a tablet terminal, a wearable terminal, or the like. The wearable terminal is smart glasses, a head-mounted display, or the like.

A plurality of constituent elements disclosed in the above-described embodiment and modifications can be appropriately combined as necessary. Alternatively, some constituent elements may be deleted from all the constituent elements shown in the above-described embodiment and modifications.

### EXAMPLES

Next, the embodiment of the present disclosure will be described more specifically with reference to Examples, but the embodiment of the present disclosure is not limited to the description of the following Examples as long as it is within the scope of the gist of the present disclosure.

### (Example 1)

A silicon wafer was prepared as the base material 30. The size S1 of the base material 30 in plan view was 150 mm. The thickness T11 of the base material 30 was 625 µm.

The mask 20 was fabricated based on the method shown in Figs. 15 to 23. The first regions 41 and the second region 42 of the mask layer 40 include a metal layer 50 including nickel. The metal layer 50 was formed by the electrolytic plating step. The metal layer 50 had a thickness of 4.0 µm. The sizes R1 and R2 of the second openings 43 of the mask layer 40 were 5.5 µm and 3.3 µm, respectively.

In the polishing step, a slurry including abrasive grains containing alumina was used. The material of the polishing pad was polyurethane. The conditions of the polishing step in Example 1 were adjusted such that both the first arithmetic mean roughness Ra1 and the second arithmetic mean roughness Ra2 were 10 nm or less.

The first arithmetic mean roughness Ra1, the first arithmetic mean roughness Sa1, and the first maximum height Sz1 of the first regions 41 of the mask layer 40, and the second arithmetic mean roughness Ra2, the second arithmetic mean roughness Sa2, and the second maximum height Sz2 of the second region 42 were calculated. Specifically, the arithmetic mean roughness Ra, the arithmetic mean roughness Sa, and the maximum height Sz were measured with a laser microscope at 25 points on the second surface 402 of the first regions 41 and 25 points on the twenty-first region 421 of the second region 42.

As the laser microscope, VK-X250 and VK-X260 manufactured by Keyence Corporation were used. The conditions and settings of the laser microscope were as follows.
·Laser light: blue (wavelength 408 nm)
·Objective lens when measuring the first regions 41: 150×
·Objective lens when measuring the second region 42: 50×
·Optical zoom: 1.0×
·Measurement mode: single screen
·Resolution: 1024 × 768
·Measurement quality: High-precision
·Double scan: Enabled
·Removal of waviness: Enabled
·Height level cut: Enabled

In measuring the arithmetic mean roughness Sa and the maximum height Sz, data on the height of the surface of the second surface 402 is acquired at each position within the quadrangles Ms shown in Fig. 14. Since the resolution is 1024 × 768, the number of data items is 786432.

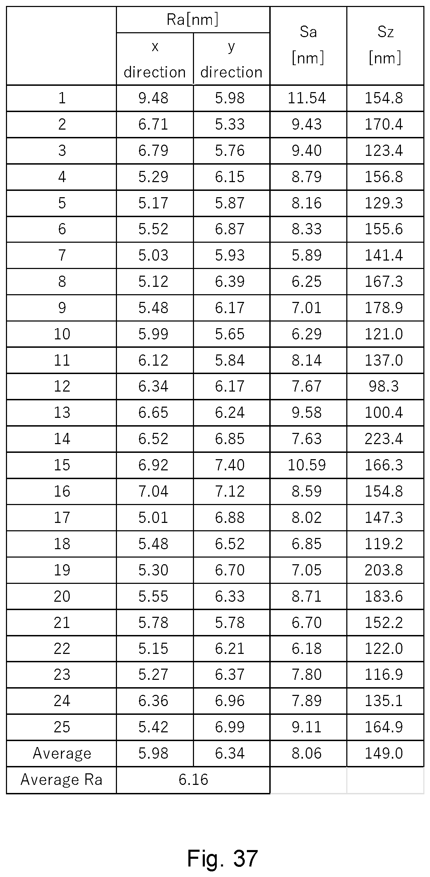

Fig. 37 is a table showing the measurement results of the arithmetic mean roughness Ra, the arithmetic mean roughness Sa, and the maximum height Sz at the 25 points in the first regions 41. At each of the 25 points, the arithmetic mean roughness Ra in the x direction Dx, the arithmetic mean roughness Ra in the y direction Dy, the arithmetic mean roughness Sa, and the maximum height Sz were measured. The first arithmetic mean roughness Ra1 is the average of 50 measured values of the arithmetic mean roughness Ra. The first arithmetic mean roughness Ra1 was 6.16 nm. The deviation between the arithmetic mean roughness Ra in the x direction Dx and the arithmetic mean roughness Ra in the y direction Dy was 0.06. The first arithmetic mean roughness Sa1 was 8.06 nm. The first maximum height Sz1 was 149.0 nm.

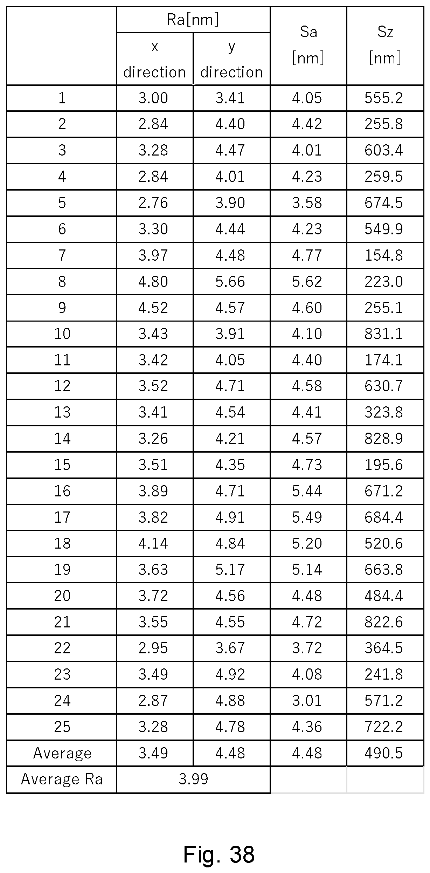

Fig. 38 is a table showing the measurement results of the arithmetic mean roughness Ra, the arithmetic mean roughness Sa, and the maximum height Sz at the 25 points in the second region 42. At each of the 25 points, the arithmetic mean roughness Ra in the x direction Dx, the arithmetic mean roughness Ra in the y direction Dy, the arithmetic mean roughness Sa, and the maximum height Sz were measured. The second arithmetic mean roughness Ra2 is the average of 50 measured values of the arithmetic mean roughness Ra. The second arithmetic mean roughness Ra2 was 3.99 nm. The deviation between the arithmetic mean roughness Ra in the x direction Dx and the arithmetic mean roughness Ra in the y direction Dy was 0.25. The second arithmetic mean roughness Sa2 was 4.48 nm. The second maximum height Sz2 was 490.5 nm.

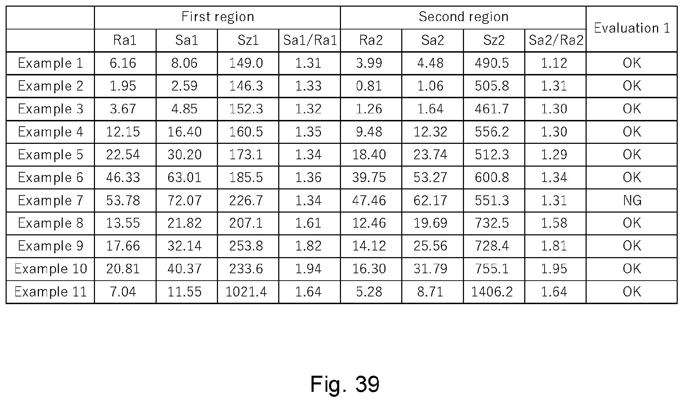

The first arithmetic mean roughness Ra1, the first arithmetic mean roughness Sa1, the first maximum height Sz1, Sa1/Ra1, the second arithmetic mean roughness Ra2, the second arithmetic mean roughness Sa2, the second maximum height Sz2, and Sa2/Ra2 in Example 1 are collectively shown in the table of Fig. 39.

Evaluation 1 regarding the performance of the mask 20 was performed.

### [Evaluation 1]

A vapor deposition step for forming a vapor deposition layer on the substrate 110 using the mask 20 was performed. The vapor deposition material was tris(8-quinolinolato)aluminum. The target thickness of the vapor deposition layer was 50 nm. In the vapor deposition step, the mask 20 was attracted to the substrate 110 using the magnet 5.

An image of the substrate on which a plurality of vapor deposition layers were formed was obtained using an optical microscope. Three observers visually checked whether the outlines of the vapor deposition layers were blurred. As the optical microscope, MX63 manufactured by Olympus Corporation was used. The optical microscope conditions and settings were as follows.
·Eyepiece lens: 10×
·Objective lens: 50×

When all three observers determined that the outlines of the vapor deposition layers were not blurred, the result of Evaluation 1 was determined to be "OK". When at least one of the three observers determined that the outlines of the vapor deposition layers were blurred, the result of Evaluation 1 was determined to be "NG".

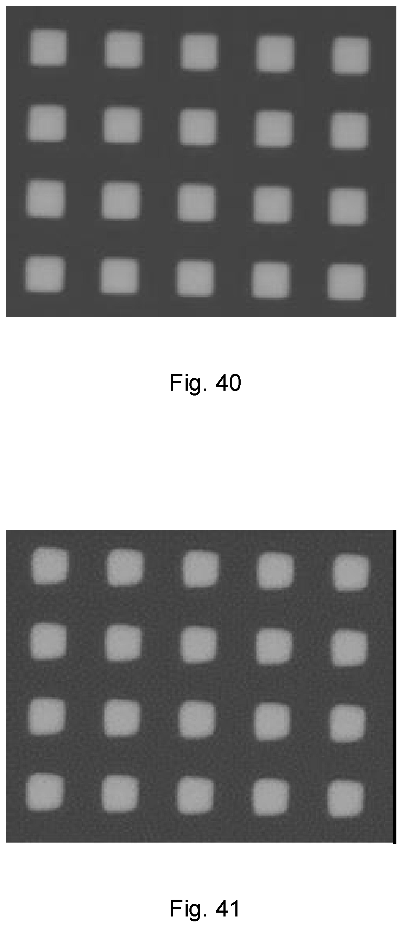

Fig. 40 is an example of an image of a plurality of vapor deposition layers for which the result of Evaluation 1 was determined to be "OK". Fig. 41 is an example of an image of a plurality of vapor deposition layers for which the result of Evaluation 1 was determined to be "NG".

### (Examples 2 to 7)

As in the case of Example 1, the mask 20 was fabricated based on the method shown in Figs. 15 to 23. In the polishing step, the slurry containing abrasive grains containing alumina and the polishing pad made of polyurethane were used as in Example 1. The rotation speed and the pressure, as well as the polishing time, of the polishing step are different among Examples 1 to 7.

As in the case of Example 1, the first arithmetic mean roughness Ra1, the first arithmetic mean roughness Sa1, and the first maximum height Sz1 of the first regions 41, and the second arithmetic mean roughness Ra2, the second arithmetic mean roughness Sa2, and the second maximum height Sz2 of the second region 42 were calculated. As in the case of Example 1, Evaluation 1 was carried out. The results of Examples 2 to 7 are shown in the table of Fig. 39.

### (Examples 8 to 10)

As in the case of Example 1, the mask 20 was fabricated based on the method shown in Figs. 15 to 23. The metal layer 50 was formed by the electrolytic plating step. In the electrolytic plating step, a higher current density was employed than in Example 1. In Examples 8 to 10, the current density of the electrolytic plating step varies from each other.

In the polishing step of Examples 8 to 10, a slurry containing abrasive grains containing alumina and a polishing pad made of polyurethane were used. The rotation speed and pressure of the polishing step, as well as the polishing time, are the same as in Example 1.

As in the case of Example 1, the first arithmetic mean roughness Ra1, the first arithmetic mean roughness Sa1, and the first maximum height Sz1 of the first regions 41, and the second arithmetic mean roughness Ra2, the second arithmetic mean roughness Sa2, and the second maximum height Sz2 of the second region 42 were calculated. As in the case of Example 1, Evaluation 1 was carried out. The results of Examples 8 to 10 are shown in the table of Fig. 39.

### (Example 11)

As in the case of Example 1, the mask 20 was fabricated based on the method shown in Figs. 15 to 23. The metal layer 50 was formed by an electrolytic plating step. In the electrolytic plating step, a higher current density was employed compared to Example 1.

In the polishing step of Example 11, a slurry containing abrasive grains containing alumina and a polishing pad made of polyurethane were used. The size of the alumina abrasive grains in the slurry used in Example 11 was larger than that in Example 1.

As in the case of Example 1, the first arithmetic mean roughness Ra1, the first arithmetic mean roughness Sa1, and the first maximum height Sz1 of the first regions 41, and the second arithmetic mean roughness Ra2, the second arithmetic mean roughness Sa2, and the second maximum height Sz2 of the second region 42 were calculated. As in the case of Example 1, Evaluation 1 was carried out. The results of Example 11 are shown in the table of Fig. 39.

As shown in Fig. 39, in Examples 1 to 6 and 8 to 9, the first arithmetic mean roughness Ra1 was not more than 50 nm, the first maximum height Sz1 was not more than 1000 nm, and Sa1/Ra1 was not more than 1.82. In Examples 1 to 6 and 8 to 9, the results of Evaluation 1 were "OK". In Example 7, the first arithmetic mean roughness Ra1 was greater than 50 nm. In Example 10, Sa1/Ra1 was greater than 1.82. In Example 11, the first maximum height Sz1 was larger than 1000 nm. In Examples 7 and 10 to 11, the results of Evaluation 1 were "NG".

## Claims

1. A mask comprising:
a base material including a base material first surface, a base material second surface located on a side opposite to the base material first surface, and at least one first opening penetrating from the base material first surface to the base material second surface; and
a mask layer including a first surface facing the base material second surface and a second surface located on a side opposite to the first surface,
wherein the mask layer includes a plurality of first regions overlapping the first opening in plan view and a second region located between, and outside of, the plurality of first regions in plan view,
the plurality of first regions each include a plurality of second openings penetrating from the first surface to the second surface,
the second surface of the first regions has a first arithmetic mean roughness (Ra1) relating to line roughness, and a first arithmetic mean roughness (Sa1) and a first maximum height (Sz1) relating to surface roughness,
the first arithmetic mean roughness (Ra1) is 50 nm or less,
the first maximum height (Sz1) is 1000 nm or less, and
Sa1/Ra1, which is a ratio of the first arithmetic mean roughness (Sa1) to the first arithmetic mean roughness (Ra1), is 1.82 or less.

2. The mask according to claim 1, wherein the second surface of the second region has a second arithmetic mean roughness (Ra2) relating to line roughness, and
the first arithmetic mean roughness (Ra1) is different from the second arithmetic mean roughness (Ra2).

3. The mask according to claim 2, wherein the first arithmetic mean roughness (Ra1) is greater than the second arithmetic mean roughness (Ra2).

4. The mask according to claim 1, wherein the second surface of the second region has a second arithmetic mean roughness (Sa2) relating to surface roughness, and
the first arithmetic mean roughness (Sa1) is different from the second arithmetic mean roughness (Sa2).

5. The mask according to claim 4, wherein the first arithmetic mean roughness (Sa1) is greater than the second arithmetic mean roughness (Sa2).

6. The mask according to claim 1, wherein the second surface of the second region has a second maximum height (Sz2) relating to surface roughness, and
the first maximum height (Sz1) is different from the second maximum height (Sz2).

7. The mask according to claim 6, wherein the first maximum height (Sz1) is smaller than the second maximum height (Sz2).

8. The mask according to any one of claims 1 to 7, wherein in-plane directions of the second surface include an x direction and a y direction orthogonal to the x direction,
the first arithmetic mean roughness (Ra1) is an average of an arithmetic mean roughness of the second surface of the first regions in the x direction and an arithmetic mean roughness of the second surface of the first regions in the y direction, and
a ratio of a difference between the arithmetic mean roughness of the second surface of the first regions in the x direction and the arithmetic mean roughness of the second surface of the first regions in the y direction to the first arithmetic mean roughness (Ra1) is 0.50 or less.

9. The mask according to any one of claims 1 to 7, wherein the first regions include a metal layer.

10. The mask according to claim 9, wherein the second region includes a metal layer.

11. The mask according to claim 9, wherein the second region includes an insulating layer.

12. The mask according to claim 11, wherein the insulating layer contains silicon oxide.

13. The mask according to any one of claims 1 to 7, further comprising an intermediate layer that is located between the mask layer and the base material and that contains metal.

14. The mask according to any one of claims 1 to 4, wherein the base material contains silicon or a silicon compound.

15. A method for manufacturing a mask, the method comprising:
a base material preparation step of preparing a base material including a base material first surface and a base material second surface located on a side opposite to the base material first surface;
an insulating layer forming step of forming an insulating layer including an insulating first surface facing the base material second surface and an insulating second surface located on a side opposite to the insulating first surface, and including at least a plurality of island portions;
a metal layer forming step of forming a metal layer between the plurality of island portions, the metal layer including a metal first surface facing the base material second surface and a metal second surface located on a side opposite to the metal first surface;
a polishing step of polishing the metal second surface;
an insulating layer removing step of removing the plurality of island portions; and
a base material processing step of forming a first opening in the base material, the first opening overlapping the metal layer in plan view,
wherein the mask includes a mask layer including a plurality of first regions including the metal layer overlapping the first opening in plan view and a second region including the metal layer or the insulating layer located between, and outside of, the plurality of first regions in plan view,
the mask layer includes a first surface facing the base material second surface and a second surface located on a side opposite to the first surface,
the second surface of the first regions has a first arithmetic mean roughness (Ra1) relating to line roughness, and a first arithmetic mean roughness (Sa1) and a first maximum height (Sz1) relating to surface roughness,
the first arithmetic mean roughness (Ra1) is 50 nm or less,
the first maximum height (Sz1) is 1000 nm or less, and
Sa1/Ra1, which is a ratio of the first arithmetic mean roughness (Sa1) to the first arithmetic mean roughness (Ra1), is 1.82 or less.

16. The method for manufacturing a mask according to claim 15, wherein the polishing step includes a step of bringing a slurry containing a working fluid and abrasive grains into contact with the insulating second surface and the metal second surface.

17. The method for manufacturing a mask according to claim 16, wherein the second surface of the second region has a second arithmetic mean roughness (Ra2) relating to line roughness, and
the first arithmetic mean roughness (Ra1) is different from the second arithmetic mean roughness (Ra2).

18. The method for manufacturing a mask according to claim 17, wherein the first arithmetic mean roughness (Ra1) is greater than the second arithmetic mean roughness (Ra2).

19. The method for manufacturing a mask according to any one of claims 15 to 18, wherein, in the metal layer forming step, the metal layer is also formed outside the plurality of island portions, and
the second region includes the metal layer located outside the plurality of first regions.

20. The method for manufacturing a mask according to any one of claims 15 to 18, wherein the insulating layer forming step forms the insulating layer including a frame portion that defines outlines of a plurality of insulating openings, and the plurality of island portions located in each of the plurality of insulating openings, and
the metal layer forming step forms the metal layer in the plurality of insulating openings.
